# EUROPEAN PATENT SPECIFICATION

(11) **EP 2 787 039 B1**
(45) Date of publication and mention of the grant of the patent: **15.08.2018**
(21) Application number: 12853475.7
(22) Date of filing: 24.10.2012
(51) Int. Cl.: C08G 59/18, C08L 33/08, C08L 79/08, C09J 7/10, C08G 59/24, C08K 3/36, C08K 9/04, C08K 9/10, C08L 63/00, H01L 23/00

(54) **RESIN COMPOSITION, RESIN COMPOSITION SHEET, SEMICONDUCTOR DEVICE AND METHOD FOR MANUFACTURING SAME**
HARZZUSAMMENSETZUNG, HARZZUSAMMENSETZUNGSFOLIE, HALBLEITERBAUELEMENT UND HERSTELLUNGSVERFAHREN DAFÜR
COMPOSITION DE RÉSINE, FEUILLE DE COMPOSITION DE RÉSINE, DISPOSITIF SEMI-CONDUCTEUR ET LEUR PROCÉDÉ DE FABRICATION

(30) Priority: 29.11.2011 JP 2011259868
(43) Date of publication of application: 08.10.2014
(73) Proprietor: Toray Industries, Inc., Tokyo 103-8666 (JP)
(72) Inventor: SHIMBA, Yoichi, Otsu-shi Shiga 520-8558 (JP); FUJIMARU, Koichi, Otsu-shi Shiga 520-8558 (JP); NONAKA, Toshihisa, Otsu-shi Shiga 520-8558 (JP)
(74) Representative: Hoefer & Partner Patentanwälte mbB
(86) International application number: PCT/JP2012/077430
(87) International publication number: WO 2013/080708

(56) References cited:
- EP-A1- 2 166 029
- WO-A1-2011/004706
- JP-A- 2000 239 355
- JP-A- 2003 105 168
- JP-A- 2011 174 035
- JP-A- 2011 233 633
- US-A1- 2002 077 421

## Description

### TECHNICAL FIELD

The present invention relates to a resin composition that can be used for adhesion between an electronic component part or a heat dissipation plate for use in a personal computer or a mobile terminal and a substrate, such as a printed board or a flexible substrate, adhesion between electronic component parts, and adhesion between substrates. More particularly, the present invention relates to a resin composition and the like that are used in adhering a semiconductor chip, such as an IC or an LSI, to a circuit board, such as a flexible substrate, a glass epoxy substrate, a glass substrate, a ceramic substrate or a silicon interposer, or for junction between semiconductor chips and lamination of semiconductor chips, such as three-dimensional packaging. Furthermore, the present invention relates to a resin composition that can be used for an insulation layer, an etching resist, or a solder resist that are for use in production of a circuit board such as a buildup multilayer substrate.

### BACKGROUND ART

In recent years, in connection with miniaturization and densification of a semiconductor device, flip chip packaging has attracted attention as a method of mounting a semiconductor chip on a circuit board, and has been quickly spreading. In the flip chip packaging, as a method for securing the connection reliability of a joining section, the adhering of a semiconductor chip and a circuit board by using a resin composition is adopted as a common method. Herein, as an application method for a resin composition, there are a method in which a paste-state material containing a large amount of solvent is inserted between objects to be adhered, and then the solvent removal and the hardening of the resin composition are carried out by thermocompression bonding, and a method in which a sheet-shaped resin composition is produced beforehand, and is inserted between objects to be adhered, and then the hardening of the resin composition is carried out by thermocompression bonding. Alternatively, in production of a buildup multilayer substrate in which a conductor layer and an insulation layer are alternately layered, there is a method in which a hardened material of a resin composition is used as an insulation layer. These resin compositions are being increasingly used for various uses in electrics, electronics, building, motor vehicles, and aviation (refer to, e.g., the patent documents 1 to 4).

Sheet-shaped resin compositions in consideration of the ease of handling at room temperature, are designed not to adhere at room temperature but to soften and adhere when heated to about 100°C. Herein, the melt viscosity of such a resin composition when it is soften by heating is preferred to be low. However, there is a problem that the hardening of the resin composition gradually progresses and the melt viscosity thereof increases. Therefore, improvement in preservation stability has been desired. In response to this, a technology of improving the preservation stability at less than or equal to 100°C by using a microcapsule type hardening acceleration agent has been proposed (refer to, for example, the patent document 5).
Furthermore, there is a problem that as the hardened material of a resin composition greatly expands or shrinks due to a temperature change, stress occurs in a semiconductor device, degrading the reliability of the device. In response to this, a technology in which inorganic particles are mixed in the resin composition in order to bring the coefficient of linear expansion of the hardened material of a resin composition closer to a low coefficient of linear expansion of a semiconductor chip or the circuit board is known.

### PRIOR-ART DOCUMENTS

### PATENT DOCUMENTS

Patent document 1: Japanese Patent Application Publication No. 2011-95731
Patent document 2: Japanese Patent Application Publication No. 2011-29232
Patent document 3: Japanese Patent Application Publication No. 2011-202177
Patent document 4: Japanese Patent Application Publication No. 2010-116453
Patent document 5: Japanese Patent Application Publication No. 2009-194054

### SUMMARY OF THE INVENTION

### PROBLEM TO BE SOLVED BY THE INVENTION

Since the resin composition in which a large amount of inorganic particles is mixed is high in melt viscosity, there has been a problem that when an electronic component part and a substrate are adhered via a resin composition and electrodes thereof are electrically connected to each other, burial of the electrodes in the resin composition becomes insufficient, so that the reliability of the electrical connection of the joined portions deteriorates. Furthermore, there has been a problem that during preservation of a paste-state resin composition, inorganic particles gradually aggregates together or the hardening of the resin progresses and the viscosity increases. Due to this, for example, in the case where the paste-state resin composition is formed into a sheet state, the flatness deteriorates so that adhesion of an electronic component part, a substrate, etc. cannot be favorably carried out.

As for the present invention, it is an object to provide a resin composition containing inorganic particles which is low in melt viscosity and excellent in preservation stability, and a hardened material of which is good in endurance with respect to a thermal cycle test and which can provide a semiconductor device that is high in connection reliability.

### MEANS FOR SOLVING THE PROBLEM

The present invention is a resin composition which contains (a) an epoxy compound, (b) a microcapsule type hardening acceleration agent, and (c) an inorganic particle whose surface is modified with a compound that has an unsaturated double bond, and (d) a compound that has (d1) a group selected from an acryloxy group and a methacryloxy group and (d2) a group selected from a carboxyl group and a hydroxyl group.

Furthermore, another aspect of the present invention is a resin composition sheet comprising the resin composition mentioned above.

Furthermore, another aspect of the present invention is a semiconductor device in which two circuit members are electrically connected via the resin composition or the resin composition sheet mentioned above.

Furthermore, another aspect of the present invention is a production method for a semiconductor device in which the resin composition or the resin composition sheet mentioned above is interposed between a first circuit member and a second circuit member, and the first circuit member and the second circuit member are electrically connected by heating and pressurizing.

### EFFECTS OF THE INVENTION

The resin composition of the present invention is low in melt viscosity and good in preservation stability. Furthermore, a hardened material of the resin composition is good in endurance with respect to a thermal cycle test and therefore a circuit board or a semiconductor device that is high in connection reliability can be provided.

### FORMS FOR CARRYING OUT THE INVENTION

The resin composition of the present invention contains (a) an epoxy compound. The (a) epoxy compound hardens due to ring opening that is generally not accompanied by shrinkage, so that it becomes possible to reduce the shrinkage at the time of the hardening of the resin composition. The (a) epoxy compound is preferred to be one that has two or more epoxy groups or one whose epoxy equivalent is 100 to 500. If the epoxy equivalent is greater than or equal to 100, the toughness of the hardened material of the resin composition becomes great. If the epoxy equivalent is less than or equal to 500, the hardened material of the resin composition has a network structure that is high in density, and the insulation property of the hardened material of the resin composition becomes good.

As the (a) epoxy compound, either one of an epoxy compound that is in a liquid state at room temperature and an epoxy compound that is in a solid state at room temperature can be used. The two may be used in combination. If the content ratio of the liquid-state epoxy compound is greater than or equal to 20 wt% relative to the entire amount of the (a) epoxy compound, the viscosity of the resin composition becomes low and therefore the adhesion property improves; therefore, it is preferable. Furthermore, the plasticity and flexibility of the resin composition will heighten. Furthermore, if the content ratio of the liquid-state epoxy compound is less than or equal to 60 wt% relative to the entire amount of the (a) epoxy compound, the tackiness of the resin composition at room temperature decreases so that the handling thereof becomes easy; therefore, it is more preferable. Herein, being in a liquid state at room temperature refers to exhibiting a viscosity less than or equal to 150 Pa•s at 25°C, and being in a solid state refers to exhibiting a viscosity exceeding 150 Pa•s at 25°C.

As the epoxy compound that is in a liquid state at room temperature, there can be cited jER 828, jER 1750, jER 152, jER 630 and jER YL980 (which are trade names, made by Mitsubishi Chemical Corporation), EPICLON (registered trademark) HP-4032 (trade name, made by DIC Corporation), etc., but these do not limit the aforementioned epoxy compound. Two or more species of these may be combined.

Furthermore, as the epoxy compound that is in a solid state at room temperature, there can be cited jER 1002, jER 1001, YX4000H, jER 4004P, jER 5050, jER 154, jER 157S70, jER 180S70 and jER YX4000H (which are trade names, made by Mitsubishi Chemical Corporation), TEPIC (registered trademark) S, TEPIC (registered trademark) G, TEPIC (registered trademark) P (which are trade names, made by Nissan Chemical Industries Ltd.), Epotohto (registered trademark) YH-434L (trade name, made by Nippon Steel Chemical Co., Ltd.), EPPN502H and NC3000 (which are trade names, made by Nippon Kayaku Co., Ltd.), EPICLON (registered trademark) N-695, EPICLON (registered trademark) N-865, EPICLON (registered trademark) HP-7200, EPICLON (registered trademark) HP-7200H (which are trade names, made by DIC Corporation), etc., but these do not limit the aforementioned epoxy compound. Two or more species of these may be combined.

Among these, epoxy compounds having a dicyclopentadiene skeleton, in particular, are capable of favorably keeping the dispersibility of inorganic particles and enhancing the preservation stability of the resin composition, and therefore are preferable. As epoxy compounds having a dicyclopentadiene skeleton, there can be cited, for example, HP-7200 and HP-7200H mentioned above.

The (a) epoxy compound affects the viscoelastic behavior at the time of raising the temperature of the resin composition. If the temperature is raised from room temperature, the viscosity of the resin composition decreases, but the viscosity exhibits a lowest point at around 100°C, and increases at temperatures higher than or equal to 100°C. This is because the (a) epoxy compound within the resin composition begins to harden. The value of the lowest viscosity at this time is termed minimum melt viscosity of the resin composition. For example, in the case where a semiconductor chip is to be adhered to a circuit board via the resin composition, a bump electrode formed on the semiconductor chip and a pad electrode of the circuit board contact and become electrically connected to each other by pushing the resin composition away. If the minimum melt viscosity of the resin composition is sufficiently low, it is possible that when the semiconductor chip is adhered to the circuit board via the resin composition, the electrodes on the circuit board and the semiconductor chip can easily push away the resin composition and therefore the counter electrodes will contact well, whereby electrical connection of the electrodes is certainly accomplished simultaneously with adhesion between the semiconductor chip and the circuit board; therefore, it is preferable. Furthermore, if the temperature at which the resin composition exhibits its minimum melt viscosity is greater than or equal to 100°C, the hardening of the resin composition does not readily progress when it is stored at a temperature lower than or equal to 100°C; therefore the preservation stability of the resin composition heightens, and it is preferable.

The minimum melt viscosity of the resin composition is preferred to be in the range of 10 to 10000 Pa•s. A more preferable range of the minimum melt viscosity is 100 to 5000 Pa•s. If the minimum melt viscosity is in this range, the aforementioned connection of electrodes becomes good, and, in addition, the resin composition in a sheet state can be laminated to a semiconductor wafer or a circuit board without wrinkle or air bubbles trapped in, and, further, bleed of the resin composition at the time of packaging a semiconductor chip can be reduced. As used herein, the minimum melt viscosity of the resin composition can be measured, for example, with respect to specimens whose dimensions are 15 mm in diameter and 0.8 mm in thickness, through the use of a dynamic viscoelasticity measurement device "AG-G2" (trade name, made by TA instruments), at a measurement frequency of 0.5 Hz and a temperature rise rate of 2°C/min and in a measurement temperature range of 40°C to 150°C.

The resin composition of the present invention contains (b) a microcapsule type hardening acceleration agent. The microcapsule type hardening acceleration agent is an agent that contains a hardening acceleration agent as a core component whose surroundings are covered with a microcapsule. Since in the (b) microcapsule type hardening acceleration agent, the hardening acceleration agent is protected by the microcapsule, the hardening of the (a) epoxy compound is restrained in a temperature range up to 100°C, and the preservation stability of the resin composition improves.

As the core component of the (b) microcapsule type hardening acceleration agent, there are presented, as examples, a dicyandiamide-type hardening acceleration agent, an amine adduct-type hardening acceleration agent, an organic acid hydrazide-type hardening acceleration agent, an aromatic sulfonium salt-type hardening acceleration agent, etc. Furthermore, as the microcapsule that covers the core component, there are presented, as examples, a vinyl compound, a urea compound, an isocyanate compound, a thermoplastic resin, etc.

The content of the (b) microcapsule type hardening acceleration agent is preferred to be 0.1 to 50 parts by weight relative to 100 parts by weight of the (a) epoxy compound. If the content of the (b) microcapsule type hardening acceleration agent is greater than or equal to 0.1 parts by weight relative to 100 parts by weight of the (a) epoxy compound, the connection reliability of a semiconductor device produced by using this resin composition heightens. It is particularly preferable that the content of the (b) microcapsule type hardening acceleration agent be greater than or equal to 10 parts by weight relative to 100 parts by weight of the (a) epoxy compound. In this case, it becomes possible to carry out the hardening of the resin composition in a short time even at low temperature. The hardening temperature and time are, for example, a temperature of 160°C to 200°C and a time of 5 seconds to 20 minutes, but are not limited so. Furthermore, if the content of the (b) microcapsule type hardening acceleration agent is less than or equal to 50 parts by weight relative to 100 parts by weight of the (a) epoxy compound, the preservation stability of the resin composition at or below 100°C heightens. Furthermore, the water absorbency of the hardened material of the resin composition is restrained, and the hardened material comes to have a high strength and a high toughness, and the connection reliability of the semiconductor device produced by using this resin composition improves.

The (b) microcapsule type hardening acceleration agent that does not dissolve in the individual components contained in the resin composition is preferably used. As concrete examples of the (b) microcapsule type hardening acceleration agent, NOVACURE (registered trademark) HX-3941HP, NOVACURE (registered trademark) HX-3922HP, NOVACURE (registered trademark) HX-3932HP and NOVACURE (registered trademark) HX-3042HP (which are trade names, made by Asahi Kasei E-materials Corp.), which are microcapsule type hardening acceleration agents obtained by covering an amine adduct-type hardening acceleration agent with an isocyanate compound, etc. are preferably used.

As the (b) microcapsule type hardening acceleration agent, a hardening acceleration agent composition that exists in a state of being dispersed in a liquid-state epoxy compound can be used. For example, NOVACURE (registered trademark) (trade name, made by Asahi Kasei E-materials Corp.) series, which are commercially available microcapsule type hardening acceleration agents, are sold as hardening acceleration agent compositions in which 200 parts by weight of a liquid-state epoxy compound is contained relative to 100 parts by weight of the (b) microcapsule type hardening acceleration agent. Therefore, in the case where a NOVACURE (registered trademark) series product is used as the (b) microcapsule type hardening acceleration agent, it is necessary that in calculation of the content of each component in the resin composition, the liquid-state epoxy compound contained in the hardening acceleration agent composition be included in the calculation as (a) an epoxy compound. Then, what is obtained by subtracting from the weight of the entire hardening acceleration agent composition the weight of the liquid-state epoxy compound contained therein is the weight of the (b) microcapsule type hardening acceleration agent.

The dispersed particle diameter of the (b) microcapsule type hardening acceleration agent is preferred to be 0.5 to 5 µm. Herein, the dispersed particle diameter shows an average particle diameter of the (b) microcapsule type hardening acceleration agents that exist spatially separately from each other. In the case where the shape of the (b) microcapsule type hardening acceleration agent is spherical, the diameter thereof is determined as the dispersed particle diameter. In the case where the shape of the (b) microcapsule type hardening acceleration agent is elliptical or a flattened shape, the maximum length of such a shape is determined as the dispersed particle diameter. Furthermore, in the case where the shape is a rod shape or a fiber shape, the maximum length in the lengthwise direction is determined as the dispersed particle diameter.

Furthermore, the light transmittance of the resin composition can be heightened by lessening the difference between the refractive index of a medium made up of the (a) epoxy-compound and other constituent materials and the refractive index of the (b) microcapsule type hardening acceleration agent.

Furthermore, in addition to the (b) microcapsule type hardening acceleration agent, other hardening acceleration agents may be used. As these, concretely, there can be cited an amine-based acceleration agent, a phosphine-based acceleration agent, a phosphonium-based acceleration agent, a sulfonium-based acceleration agent, and an iodonium-based acceleration agent.

The resin composition of the present invention contains (c) an inorganic particle whose surface is modified with a compound that has an unsaturation double bond. Herein, a "surface being modified with a compound that has an unsaturated double bond" expresses that, on a portion or the whole of a particle's surface, a compound having an unsaturated double bond is bound to an atom in the particle's surface by covalent bonding, ion bonding, etc. For example, in the case where a silane coupling agent cited below is used as a compound having an unsaturated double bond, hydroxyl groups on the surface of the particle and silanol groups of the silane coupling agent form covalent bonds by dehydration condensation. As a method for checking that a particle's surface is modified with a compound that has an unsaturated double bond, there can be cited analyzing the particle's surface by infrared spectroscopy.

In the resin composition of the present invention, it is necessary that the surface of the inorganic particle be modified with a compound that has an unsaturated double bond, in order to restrain the increase in the viscosity of the resin composition and precipitation of aggregates in the resin composition. As the unsaturated double bond, there can be shown, as examples, a vinyl group, an acryloxy group and methacryloxy group. If the compound having an unsaturated double bond is a compound having a group selected from the acryloxy group and the methacryloxy group, the dispersibility of the inorganic particle in the presence of the epoxy compound becomes particularly good, and a uniform state of the resin composition in which there is no aggregate and the viscosity is low can be maintained; therefore, it is particularly preferable.

The compound having an unsaturated double bond which is for use for surface modification of the inorganic particle is not particularly limited; however, there can be cited, for example, a silane coupling agent having an unsaturated double bond, and concretely, there can be cited vinyl trimethoxysilane, vinyl triethoxysilane, 3-acryloxypropyl trimethoxysilane, 3-acryloxypropyl triethoxysilane, 3-methacryloxypropyl trimethoxysilane, 3-methacryloxypropyl triethoxysilane, 3-methacryloxypropyl methyl dimethoxysilane, and 3-methacryloxypropyl diethoxysilane.

As a material of the inorganic particle, silica, alumina, titania, silicon nitride, boron nitride, aluminum nitride, iron oxide, glass, other metal oxides, metal nitrides, metal carboxylates, and metal sulfates such as barium sulfate, etc. can be used alone or in combination of two or more species thereof. Among these, silica can be particularly preferably used in respect of low thermal expansibility, low water absorbency and high dispersibility.

The content of the inorganic particle is preffered to be 40 to 70 wt% relative to the solid content, that is, the amount of components obtained by excluding volatile components, such as the solvent from the resin composition. If the content of the inorganic particle is greater than or equal to 40 wt%, the foaming at the time of heating and hardening the resin composition decreases, and the coefficient of linear expansion of the hardened material of the resin composition becomes low, so that the connection reliability of the semiconductor devices produced by using the resin composition heightens. In particular, good connection reliability can be maintained in the case where the semiconductor device is subjected to a treatment that requires a stronger durability, such as a moisture-absorption reflow treatment or a thermal cycle treatment. Furthermore, the attachment marks produced on the resin composition's surface when the semiconductor chip equipped with the resin composition is transported with a vacuum attachment collet can be reduced. Furthermore, the creeping up of the resin composition to the chip side surface which occurs when the semiconductor chip is mounted on the circuit board can be restrained. Therefore, even in the case where the thickness of the semiconductor chip is less than or equal to 100 µm prepared by the reverse surface grinding of the semiconductor wafer, packaging can be carried out without resin composition attached to the semiconductor chip reverse surface or a heating tool of a packaging device.

Furthermore, if the content of the inorganic particle is less than or equal to 70 wt%, the viscosity increase of the resin composition is restrained, and the inorganic particle uniformly disperses in the resin composition; therefore, in the case where the resin composition is applied in a sheet state, a resin composition sheet without an uneven film thickness, a pinhole, or crack. Therefore, the connection reliability of the semiconductor device produced by using this resin composition heightens. Further, due to uniform dispersion of the inorganic particle, the light transmittance of the resin composition becomes good.

The shape of the inorganic particle may be either a spherical shape or an aspherical shape such as a crushed shape or a flake shape. However, spherical inorganic particles are preferably used because they readily uniformly disperse in the resin composition.

The dispersed particle diameter of the inorganic particle is preferred to be 1 to 300 nm. If the dispersed particle diameter is greater than or equal to 1 nm, the viscosity of the resin composition is kept low, so that the surface flatness of the resin composition in the forming process improves. If the dispersed particle diameter is less than or equal to 300 nm, the light transmittance of the resin composition becomes high, and the visibility of an alignment mark on a circuit board or a semiconductor chip on whose adherence surface a sheet-shape resin composition is formed becomes good. The dispersed particle diameter of the inorganic particle is more preferred to be less than or equal to 200 nm, and most preferred to be less than or equal to 100 nm, from the point of view of improving the light transmittance of the resin composition. Besides, from the point of view of lowering the viscosity of the resin composition, the dispersed particle diameter of the inorganic particle is more preferred to be greater than or equal to 10 nm.

As used herein, the dispersed particle diameter of the inorganic particle indicates the average particle diameter of the inorganic particles that exist separated spatially from each other. In the case where the shape of the particle is spherical, the diameter thereof is defined as the dispersed particle diameter. In the case where the shape of the particle is elliptical or flattened, the maximum length of the shape is defined as the dispersed particle diameter. Further, in the case where the shape of the particle is a rod shape or a fibrous shape, the maximum length thereof in the lengthwise direction is defined as the dispersed particle diameter. Furthermore, in particles in which several particles are aggregated to form a particle, the maximum length of such an aggregated particle is defined as the dispersed particle diameter. As for the method of measuring the dispersed particle diameter of the inorganic particle in the resin composition, it can be measured by a method in which particles are directly observed with an SEM (scanning electron microscope) and the average of the particle diameters of 100 particles is calculated. Furthermore, the dispersed particle diameter of the inorganic particles in the dispersion liquid can be measured by using "Zetasizer Nano ZS" (trade name) made by Sysmex Corporation, which is a dynamic light scattering-type particle diameter measurement device.

The resin composition of the present invention contains (d) a compound that has (d1) a group selected from an acryloxy group and a methacryloxy group and (d2) a group selected from a carboxyl group and a hydroxyl group. Thereby the fracture elongation of the hardened material of the resin composition becomes large, and therefore it is preferable. This compound (d) is termed hereinafter the acidic acrylate. Although the reason why the fracture elongation of the hardened material of the resin composition becomes large due to the presence of the acidic acrylate is not clear, it is considered that since the carboxyl group and the hydroxyl group of the acidic acrylate are acidic groups, these groups are coordinated on a surface of the (c) inorganic particle whose surface is modified with a compound that has an unsaturated double bond, and then, when the resin composition is hardened by heating, acryloxy groups and methacryloxy groups of the acidic acrylate undergo addition reactions with unsaturated double bonds in the surfaces of inorganic particles, so that the adhesion force between the resin component and the inorganic particle in the hardened material of the resin composition heightens, developing a property of being resistant to fracture and being highly tough.

The content of the acidic acrylate is preferred to be 0.01 to 5 wt% relative to the solid content, that is, the amount of conponents obtained by excluding the volatile components, such as the solvent and the like, from the resin composition. If the aforementioned content is greater than or equal to 0.01 wt%, the fracture elongation of the hardened material of the resin composition becomes large. Furthermore, if the aforementioned content is less than or equal to 5 wt%, the preservation stability of the resin composition at 100°C or below improves.

As examples of the acidic acrylate, there can be cited 2-hydroxy ethyl acrylate, 2-hydroxy ethyl methacrylate, 2-hydroxy propyl acrylate, 2-hydroxy propyl methacrylate, 2-hydroxy butyl acrylate, 2-acryloxy ethyl succinic acid, 2-acryloxy ethyl phthalic acid, 2-acryloxy ethyl hexahydrophthalic acid, 2-acryloxy ethyl-2-hydroxy ethyl phthalic acid, 2-hydroxy-3-phenoxy propyl acrylate, and 2-hydroxy-3-acryloxypropyl methacrylate. Furthermore, as commercially available acidic acrylates, there can be cited, for example, HOA-MS, HOA-MPL, HOA-MPE, epoxy ester 3000A and epoxy ester 3002A (which are trade names, made by Kyoeisha Chemical Co., Ltd.), "KAYARAD (registered trademark)" ZAR1395H, "KAYARAD (registered trademark)" ZFR1401H (which are trade names, made by Nippon Kayaku Co., Ltd.).

If the resin composition of the present invention further contains (e) an organic solvent-soluble polyimide that has an imide ring, good heat resistance and good chemical resistance develop, and therefore it is preferable. In particular, by using the (e) organic solvent-soluble polyimide that has, on an side chain thereof, at least one functional group capable of reacting with an epoxy group, the ring opening of the epoxy compound and the reaction of addition to the polyimide are accelerated at the time of heating the resin composition for the purpose of hardening, so that a hardened material of the resin composition that has a network structure of an even higher density can be obtained. As functional groups capable of reacting with the epoxy group, there can be cited phenolic hydroxyl groups, sulfonic acid groups and thiol groups. As the synthetic method for such an aromatic polyimide, which are not limited to the examples cited below, there can be cited, for example, a method in which an acid dianhydride having a group capable of reacting with the epoxy group is caused to react with diamine so as to synthesize a polyimide precursor, and this polyimide precursor is subjected to terminal modification by using a primary monoamine as a terminal sealing agent, and subsequently heating to 150°C or higher is performed to carry out the ring closing of polyimide. As another method, there can be cited a method in which acid dianhydride and primary monoamine as a terminal sealing agent are first caused to react, and then diamine is added to synthesize a terminal-modified polyimide precursor, and then the heating to 150°C or higher is carried out to carry out the ring closure of polyimide.

A preferable example of the (e) organic solvent-soluble polyimide is a polymer that has a structure represented by either one of the general formulas (2) and (3), and that has, as R⁴ in the general formulas (2) and (3), the structure represented by the general formula (1) at 5 to 15 wt% relative to the entire amount of the polymer. If the content of the structure represented by the general formula (1) is greater than or equal to 5 wt%, the polyimide can develop an appropriate softness, and if the content is less than or equal to 15 wt%, rigidity, heat resistance and insulation property of the polyimide are maintained.

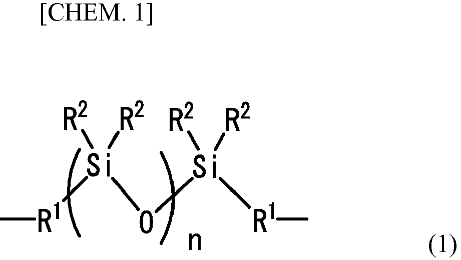

In the formula, R¹ is a bivalent hydrocarbon group. R¹ is preferably a phenylene group or an alkylene group having a carbon number of 1 to 5. R² is a monovalent hydrocarbon group. R² is preferably a phenyl group or an alkyl group having a carbon number of 1 to 5. The resin composition of the present invention may contain R¹ and R² having different structures within a molecule of the (e) organic solvent-soluble polyimide, and may also contain R¹ and R² having structures different between different molecules of the (e) organic solvent-soluble polyimides.

n shows an integer of 1 to 10, and is preferably 1 to 2. If n is greater than or equal to 1, the shrinkage of the resin composition at the time of hardening is restrained. If n is less than or equal to 10, the imide group content rate in the polyimide skeleton is high and the insulation property and the heat resistance of the hardened material of the resin composition are good.

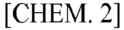

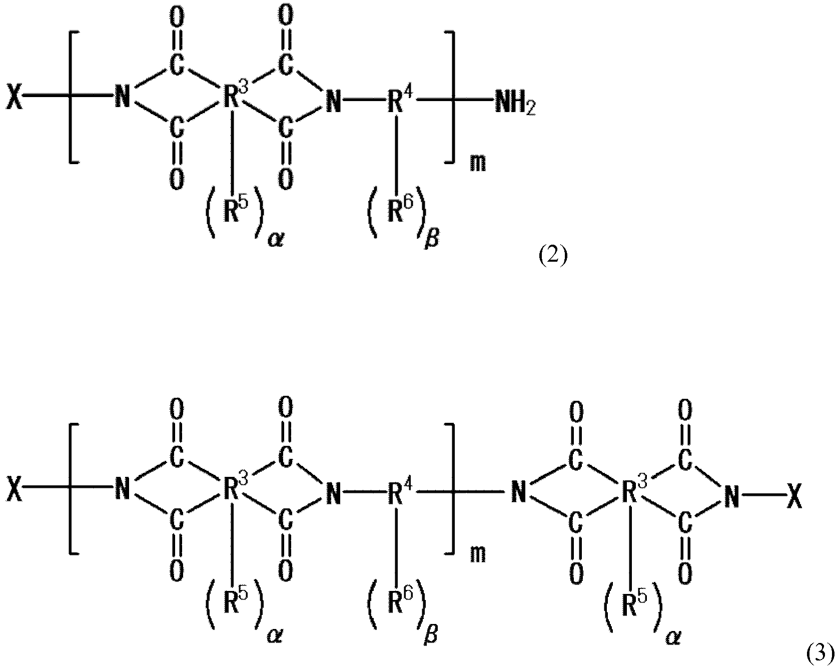

In the formula, R³ is an organic group having a valence of 4 to 14, and R⁴ is an organic group having a valence of 2 to 12. At least one of the R³ and R⁴ is an aromatic group having at least one group (hereinafter, termed the "specific group") selected from the set consisting of 1,1,1,3,3,3-hexafluoropropyl groups, isopropyl groups, ether groups, thioether groups and an SO₂ group. R⁵ and R⁶ show groups selected from the set consisting of phenolic hydroxyl groups, sulfonic acid groups and thiol groups. The resin composition of the present invention may contain R³ to R⁶ having different structures in a molecule of the (e) organic solvent-soluble polyimide, and may also contain R³ to R⁶ having structures different between different molecules of the (e) organic solvent-soluble polyimide. X shows a monovalent organic group, m is 8 to 200. α and β each show an integer of 0 to 10, and α + β is an integer of 0 to 10. However, in 20 to 90% of the repetition units, α + β = 1 to 10.

The solubility of the (e) organic solvent-soluble polyimide means dissolution thereof in a specific solvent selected from below to 20 wt% or more at 23°C. Ketone-based solvents, including acetone, methyl ethyl ketone, methyl isobutyl ketone, cyclopentanone and cyclohexanone; ether-based solvents, including 1,4-dioxane, tetrahydrofuran and DIGLYME; glycol ether-based solvents, including methyl cellosolve, ethyl cellosolve, propylene glycol monomethyl ether, propylene glycol monoethyl ether, propylene glycol monobutyl ether and diethylene glycol methyl ethyl ether; other benzyl alcohols, N-methyl pyrrolidone, γ- butyrolactone, ethyl acetate and N,N-dimethyl formamide.

In the general formula (2) and (3), R³ represents a residue of acid dianhydride, and is preferred to be an organic group having a carbon number of 5 to 40 and a valence of 4 to 14. Furthermore, R4 represents a residue of diamine, and is preferred to be an organic group having a carbon number of 5 to 40 and a valence of 2 to 12. Furthermore, it is preferable that both R³ and R⁴ have at least one of the foregoing specific groups.

X is a group derived from primary monoamine, which is a terminal sealing agent. X may be one species or a combination of two or more species. As the primary monoamine, there can be cited, for example, 5-amino quinoline, 4-amino quinoline, 3-amino naphthalene, 2-amino naphthalene, 1-amino naphthalene, aniline, etc. Among these, aniline is particularly preferably used. The content of the X component is preferred to be in the range of 0.1 to 60 mol%, and more preferred to be in the range of 5 to 50 mol%, relative to the entire diamine components.

Furthermore, the terminal sealing agent and the structure of the general formula (1) introduced into the polymer can easily be detected and quantified by a method below. For example, the terminal sealing agent and the structure of the general formula (1) can be easily detected and quantified by, for example, dissolving the polymer in which the terminal sealing agent and the structure of the general formula (1) have been introduced, in an acidic solution or a basic solution so as to be decomposed into a diamine component and an acid anhydride component that are structural units of the polymer, and then subjecting the components to measurement by using gas chromatography (GC) or NMR. Aside from this, the terminal sealing agent and the structure of the general formula (1) can also be easily detected and quantified by subjecting the polyimide with the introduced terminal sealing agent directly to measurement using a pyrolysis gas-chro chromatography (PGC), an infrared spectrum, and ¹³C-NMR.

In the general formulas (2) and (3), m shows the number of repetitions in the polymer, and is preferably 10 to 150. Expressed in the weight-average molecular weight of the polymer, it is preferred to be 4000 to 80000 in terms of polystyrene equivalent by gel filtration chromatography, and particularly preferred to be 8000 to 60000. If m is greater than or equal to 10, the viscosity of the resin composition becomes high and thick film application becomes possible. If m is less than or equal to 150, the solubility of the polyimide to the solvent improves. The weight-average molecular weight can be found by the following method. Using a polyimide solution having a solid concentration of 0.1 wt% which has been obtained by dissolving a soluble polyimide in N-methyl pyrrolidone (NMP), the polystyrene-equivalent weight-average molecular weight is calculated by a GPC device "Waters 2690" (trade name, made by Waters Corporation). As for GPC measurement conditions, the mobile phase is an NMP obtained by dissolving each of LiCl and phosphorus acid to a concentration of 0.05 mol/L, and the developing speed is 0.4 mL/min.

By selecting R⁵ and R⁶ in the general formula (2) or (3), the rate of reaction between polyimide and the (a) epoxy compound during the heating treatment can be adjusted, and the crosslink density of the hardened material of the resin composition can be adjusted. This makes it possible to give needed heat resistance and needed chemical resistance to the hardened material of the resin composition. It is preferred that 20 to 90 mol% of the total of R⁵ and R⁶ be phenolic hydroxyl groups, sulfonic acid groups and thiol groups. By having greater than or equal to 20 mol% of these groups relative to the total of R⁵ and R⁶, the heat resistance and the chemical resistance of the hardened material of the resin composition can be improved. By having less than or equal to 90 mol% of these groups, the crosslink density can be restrained in an appropriate range, and a toughness and an elongation of the hardened material of the resin composition can be maintained.

The (e) organic solvent-soluble polyimide may be such a polyimide made up of a structure represented by the general formula (2) or (3), or may also be a copolymer or a mixture that contains another structure as well. The structure represented by the general formula (2) or (3) is preferred to be contained at greater than or equal to 50 mol% relative to the entire organic solvent-soluble polyimide. The kind and amount of other structures for use in the copolymer or the mixture are preferred to be selected within a range that does not impair the heat resistance of the hardened material of the resin composition obtained through a heating treatment.

The (e) organic solvent-soluble polyimide is synthesized by utilizing a known method. For example, there can be cited a method in which a polyimide precursor is obtained by utilizing a method in which tetracarboxylic dianhydride and a diamine compound are caused to react in a low temperature, a method in which tetracarboxylic dianhydride and a diamine compound are caused to react in a low temperature, a method in which a diester is obtained through a reaction between tetracarboxylic dianhydride and an alcohol, and then is caused to react with a diamine in the presence of a condensing agent, a method in which a diester is obtained through a reaction between tetracarboxylic dianhydride and an alcohol, and then the remaining dicarboxylic acid is turned into an acid chloride, and is then caused to react with a diamine, and then the polyimide precursor is caused to undergo a known imidization reaction.

The acid dianhydride for use will be described. As the acid dianhydride having at least one of the foregoing specific groups, there can be concretely cited 2,2-bis(3,4-dicarboxyphenyl)propane dianhydride, 2,2-bis(2,3-dicarboxyphenyl)propane dianhydride, bis(3,4-dicarboxyphenyl)sulfone dianhydride, bis(3,4-dicarboxyphenyl)ether dianhydride, and 2,2-bis(3,4-dicarboxyphenyl)hexafluoropropane dianhydride, as well as compounds that have in an aromatic ring of one of these a substitution group that is an alkyl group or a halogen atom.

Furthermore, other acid dianhydrides, concretely, aromatic tetracarboxylic dianhydrides, such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenone tetracarboxylic dianhydride, 2,2',3,3'-benzophenone tetracarboxylic dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,2,5,6-naphthalenetetracarboxylic dianhydride, 2,3,6,7-naphthalenetetracarboxylic dianhydride, 2,3,5,6-pyridine tetracarboxylic dianhydride, 3,4,9,10-perylenetetracarboxylic dianhydride, or compounds having in an aromatic ring of one of these a substitution group that is an alkyl group or a halogen atom, can also be used. These acid dianhydrides are used alone or in combination of two or more species.

The diamine for use will be described. As the diamine having at least one of the aforementioned specific groups, there can be concretely cited 3,4'-diaminodiphenyl sulfide, 4,4'-diaminodiphenyl sulfide, 3,4'-diaminodiphenyl ether, 4,4'-diaminodiphenyl ether, 3,4'-diaminodiphenyl sulfone, 4,4'-diaminodiphenyl sulfone, bis[4-(4-aminophenoxy)phenyl] sulfone, bis[4-(3-aminophenoxy)phenyl] sulfone, bis(4-aminophenoxy)biphenyl, bis [4-(4-aminophenoxy)phenyl] ether, 1,4-bis(4-aminophenoxy)benzene, 1,3-bis(4-aminophenoxy)benzene, 2,2-bis[4-(4-aminophenoxy)phenyl]hexafluoropropane, and 2,2-bis[4-(4-aminophenoxy)phenyl]propane, as well as compounds having an aromatic ring of one of these a substitution group that is an alkyl group or a halogen atom.

As the diamine having at least one of the foregoing specific groups and having at least one group selected from the set consisting of a phenolic hydroxyl group, a sulfonic acid group and a thiol group, there can be concretely cited 2,2-bis(3-amino-4-hydroxyphenyl)hexafluoropropane, 2,2-bis(3-hydroxy-4-aminophenyl)hexafluoropropane, 2,2-bis(3-amino-4-hydroxyphenyl)propane, 2,2-bis(3-hydroxy-4-aminophenyl)propane, 3,3 '-diamino-4,4'-dihydroxydiphenyl ether, 3,3 '-diamino-4,4'-dihydroxydiphenyl sulfone, and 3,3'-diamino-4,4'-dihydroxydiphenyl sulfide as well as compounds having an aromatic ring of one of these a substitution group that is an alkyl group or a halogen atom.

Furthermore, other diamines, concretely, 3,3'-diamino-4,4'-dihydroxy biphenyl, 2,4-diamino-phenol, 2,5-diaminophenol, 1,4-diamino-2,5-dihydroxy benzene, diamino dihydroxy pyrimidine, diamino dihydroxy pyridine, hydroxy diamino pyrimidine, 9,9-bis(3-amino-4-hydroxyphenyl)fluorene, 3,4'-diaminodiphenylmethane, 4,4'-diaminodiphenylmethane, benzidine, m-phenylenediamine, p-phenylenediamine, 1,5-naphthalenediamine, 2,6-naphthalenediamine, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',5,5'-tetramethyl-4,4'-diaminobiphenyl, and 2,2'-di(trifluoromethyl)-4,4'-diaminobiphenyl as well as compounds having an aromatic ring of one of these a substitution group that is an alkyl group or a halogen atom, or terephthalic hydrazide, isophthalic hydrazide, phthalic hydrazide, 2,6-naphthalene dicarboxylic dihydrazide, 4,4'-bisphenyl dicarbono-hydrazine, and 4,4'-cyclohexane dicarbono-hydrazine, as well as hydrazide compounds having in an aromatic ring of one of these a substitution group that is an alkyl group or a halogen atom, can also be used. These diamines are used alone or in combination of two or more species.

Furthermore, as the diamine including a structure represented by the general formula (1), there can be cited bis(3-aminopropyl)tetramethyl disiloxane, or bis(p-amino-phenyl)octamethylpentasiloxane.

In the case where the amount of the components obtained by excluding the solvent and the inorganic particle from the resin composition is defined as 100 parts by weight, the content of the (e) organic solvent-soluble polyimide is preferred to be 10 to 20 parts by weight. If the content of the (e) organic solvent-soluble polyimide is greater than or equal to 10 parts by weight, the heat resistance of the hardened material of the resin composition is good. On the other hand, if the (e) organic solvent-soluble polyimide is less than or equal to 20 parts by weight, the water absorbency of the hardened material of the resin composition decreases, so that the adhesion force between the circuit board and the semiconductor chip increases and therefore the connection reliability improves. Furthermore, the insulation property of the hardened material of the resin composition heightens. Furthermore, if the content of the (e) organic solvent-soluble polyimide is 10 to 20 parts by weight, the minimum melt viscosity of the resin composition is low and the temperature at that time becomes high; therefore it is preferable.

The resin composition of the present invention may further contain a thermoplastic resin for the purpose of reducing stress in the post-hardening state. As the thermoplastic resin, there can be cited, for example, phenoxy resin, polyester, polyurethane, polyamide, polypropylene, acrylonitrile-butadiene copolymer (NBR), styrene-butadiene copolymer (SBR), acrylonitrile-butadiene-methacrylic acid copolymer, acrylonitrile-butadiene-acryl acid copolymer. However, the thermoplastic resin is not limited to these.

The resin composition of the present invention may contain (f) a solvent. As the (f) solvent, it is possible to use acetone, methyl ethyl ketone, methyl isobutyl ketone, cyclopentanone, and cyclohexanone, which are ketone-based solvents; 1,4-dioxane, tetrahydrofuran, and DIGLYME, which are ether-based solvents; methyl cellosolve, ethyl cellosolve, propylene glycol monomethyl ether, propylene glycol monoethyl ether, propylene glycol monobutyl ether, propylene glycol monomethyl ether acetate, propylene glycol monoethyl ether acetate, and diethylene glycol methyl ethyl ether, which are glycol ether-based solvents; and benzyl alcohols, N-methyl pyrrolidone, γ-butyrolactone, ethyl acetate, N,N-dimethyl formamide, alone or in a mixture of two or more species. However, the (f) solvent is not limited to these.

Subsequently, examples of the production method for the resin composition of the present invention will be described in detail. The resin composition of the present invention may be in the paste state or may also be in a semi-solid state that lacks fluidity but has an adhesion property at room temperature or when heated. Herein, the paste state indicates a state that has fluidity at room temperature. Furthermore, the semi-solid state indicates a state that lacks fluidity but that has an adhesion property at room temperature or when heated. Firstly, the production method for a paste-state resin composition will be described.

Firstly, an inorganic particle in a powder state in which primary particles are aggregated and a solvent are mixed, and the aggregated inorganic particles are loosened or broken to disperse in the solvent by a dispersing device, such as a homogenizer, a ball mill, or a bead mill. Next, a compound having an unsaturated double bond is mixed into the obtained dispersion liquid of the inorganic particle, and the mixture is stirred for several hours at room temperature or a temperature lower than or equal to 100°C, whereby a dispersion liquid of (c) an inorganic particle whose surface is modified with a compound that has an unsaturated double bond is obtained. Prior to the dispersion of the inorganic particle, a compound having an unsaturated double bond may be mixed into the solvent beforehand, so that the dispersion treatment and the surface treatment of the inorganic particle will be simultaneously carried out. Furthermore, it is also possible to mix another compound such as a dispersing agent or an anti-foaming agent. Furthermore, it is also possible to make use of a commercially available dispersion liquid of inorganic particle. As the commercially available dispersion liquid of inorganic particle, there can be cited, for example, "YA050C-KJC" (trade name, made by Admatechs Company Limited, a spherical silica particle, a dispersed particle diameter of 80 nm, surface treated with 3-methacryloxypropyl trimethoxysilane, a methyl isobutyl ketone dispersion liquid having a silica concentration of 50 wt%), etc. The dispersion liquid whose inorganic particle has been surface-treated may be directly used to produce a paste-state resin composition. Alternatively, the solvent may be removed from the dispersion by using a rotary evaporator or the like, and the obtained powder material of inorganic particle may be used to produce a paste-state resin composition.

Next, the dispersion liquid of inorganic particle or the surface-modified inorganic particle is mixed with (a) an epoxy compound and (b) a microcapsule type hardening acceleration agent and with (d) an acidic acrylate, and, according to need, (e) an organic solvent-soluble polyimide, (f) a solvent, a polymerization inhibitor agent, etc., to obtain a paste-state resin composition. These materials may be mixed beforehand the dispersion treatment and the surface treatment of the inorganic particle mentioned above. In that case, however, since during the dispersion treatment, the (e) organic solvent-soluble polyimide or the (a) epoxy compound may sometimes harden due to breakage of the (b) microcapsule type hardening acceleration agent, it is preferable that the materials be mixed after the dispersion treatment and the surface treatment of the inorganic particle.

As the paste-state resin composition obtained as mentioned above is formed or applied into a predetermined shape and volatile components, such as the solvent, are removed by a heating treatment, a semi-solid state resin composition can be obtained. In particular, the preparation method for a resin composition sheet obtained by forming the resin composition into a sheet state will be described in detail below.

After a paste-state resin composition is applied onto an exfoliative substrate by using a device, such as a bar coater, screen printing, a blade coater, a die coater or a comma coater, the solvent is removed to obtain a resin composition sheet. As the exfoliative substrate, there can be cited a polyethylene terephthalate film, a polyethylene naphthalate film, a polyester film, a polyvinyl chloride film, a polycarbonate film, a polyimide film, fluororesin films such as a polytetrafluoroethylene film, a polyphenylene sulfide film, a polypropylene film, a polyethylene film. However, the exfoliative substrate is not limited to these. Furthermore, the exfoliative substrate may be surfaced treated with a mold release agent such as silicon-based, long-chain-alkyl-based, fluorine-based or aliphatic amide-based ones. The thickness of the exfoliative substrate is not particularly limited, but usually is preferred to be 5 to 75 µm. From the viewpoint of capability of reducing the residual stress in the resin composition, the thickness of the exfoliative substrate is preferred to be greater than or equal to the thickness of the resin composition sheet obtained.

As a method of removing the solvent, there can be cited heating via an oven or a hot plate and also vacuum drying, and, furthermore, heating via electromagnetic waves such as infrared rays or microwaves. Herein, in the case where removal of the solvent is insufficient, it sometimes happens that when the resin composition is hardened by further heating to high temperature after a semiconductor chip or a circuit board is adhered via the resin composition, air bubbles form and the adhesion force decreases. On the other hand, if the heating for removing the solvent is excessively carried out, it sometimes happens that the hardening of the resin composition progresses and the adhesion force decreases.

It is preferable that another exfoliative substrate be stuck to an opposite side surface of the obtained resin composition sheet to the surface having the exfoliative substrate so that both surfaces of the resin composition sheet are sandwiched with the exfoliative substrates. As for the material and thickness of the another exfoliative substrate, substantially the same substrates as described above can be used. It does not matter if both of the exfoliative substrates are of the same kind. However, it is preferable that there be a difference between the adhesion forces between the resin composition and the individual exfoliative substrates. In particular, the difference between the adhesion forces is preferred to be 5 to 47 N/m. By setting the difference between the adhesion forces to greater than or equal to 5 N/m, it is possible to prevent an event in which when the one of the exfoliative substrates having the smaller adhesion force is exfoliated, the resin composition peals or floats off from the other exfoliative substrate. Furthermore, by setting the difference between the adhesion forces to less than or equal to 47 N/m, it becomes less likely that resin composition remains on the surface of the exfoliative substrate after the exfoliation.

The resin composition of the present invention can be suitably used as a resin composition for adhesion, fixation or sealing of circuit members that constitute a semiconductor device. Furthermore, the resin composition of the present invention can also be used for an insulation layer, a permanent resist, a solder resist, or a sealing agent that constitute a circuit board such as a buildup multilayer substrate, or an etching resist for use in the production of a semiconductor device. Herein, the circuit member refers to a member that constitutes a semiconductor device, such as a semiconductor chip, a chip component part, a circuit board, or a metal wiring material. As concrete examples of the circuit member, there can be cited a semiconductor chip on which a bump, such as a plated bump or a stud bump, is formed, chip component parts such as a resistor chip, a capacitor chip, a semiconductor chip having a TSV (through-silicon via) electrode, or a silicon interposer. The semiconductor device mentioned in the invention refers to devices in general that can function by utilizing a property of a semiconductor element, and semiconductor circuits and electronic appliances are all included in the semiconductor device.

The production method for a semiconductor device that uses the resin composition of the present invention will be described. The production method for a semiconductor device of the present invention is a production method for a semiconductor device in which the resin composition of the present invention is interposed between a first circuit member and a second circuit member, and the first circuit member and the second circuit member are electrically connected by heating and pressurizing.

Concretely, firstly, the first circuit member having a first connection terminal and the second circuit member having a second connection terminal are disposed so that the first connection terminal and the second connection terminal face each other. Next, the resin composition of the present invention is interposed between the first circuit member and the second circuit member disposed facing each other. Herein, as for the method of interposing the resin composition, a paste-state resin composition may be applied to a surface of the circuit member, or a resin composition film may be laminated to a surface of the circuit member. The resin composition may be formed on the connection terminal-side surface of only one of the circuit members, or may also be formed on the connection terminal-side surfaces of both of the first and second circuit members. Then, by heating and pressuring these members, the first circuit member and the second circuit member are adhered and, simultaneously, the first connection terminal and the second connection terminal disposed facing each other are electrically connected. The electrical connection of the connection terminals may be made by mechanically pressing them, or may also be made by metal joining that uses solder or the like. Furthermore, a penetrating electrode may be formed in the first circuit member and/or the second circuit member, and a connection terminal may be formed on one side surface and/or both side surfaces of the member.

Next described will be an example of a method of producing a semiconductor device in which when a semiconductor chip having a bump and a circuit board having a wiring pattern are electrically connected, the connection is made via a resin composition sheet, and an air gap between the semiconductor chip and the circuit board on which the wiring pattern is formed is sealed by a hardened material of the resin composition.

Firstly, a resin composition sheet is cut out in a predetermined size, and is laminated to a wiring pattern surface of the circuit board on which the wiring pattern has been formed. Alternatively, a semiconductor chip with the resin composition laminated thereto may be prepared by laminating a resin composition sheet to a bump-formed surface of a semiconductor wafer before it is cut into semiconductor chips, and then by dicing the semiconductor wafer into individual pieces. The laminating of the resin composition can be carried out by using a laminating device such as a roll laminator or a vacuum laminator.

After the resin composition sheet is laminated to the circuit board or the semiconductor chip, the packaging of the semiconductor chip onto the circuit board is carried out via a bonding device. The bonding condition is not particularly limited as long as such a range that electrical connection is favorably obtained is maintained. However, in order to carry out the hardening of the resin composition, it is preferable to carry out the bonding under the heating and pressurizing conditions in which the temperature is greater than or equal to 100°C, the pressure is greater than or equal to 1 mN/bump and the time is greater than or equal to 0.1 second. The packaging is carried out under the bonding conditions of a temperature of, more preferably, greater than or equal to 120°C and less than or equal to 300°C and, further preferably, greater than or equal to 150°C and less than or equal to 250°C, a pressure of, more preferably, greater than or equal to 5 mN/bump and less than or equal to 50000 mN/bump and, further preferably, greater than or equal to 10 mN/bump and 10000 mN/bump, and a time of, more preferably, greater than or equal to 1 second and less than or equal to 60 seconds and, further preferably, greater than or equal to 2 seconds and less than or equal to 30 seconds. Furthermore, it is also preferable that, at the time of bonding, the bumps on the semiconductor chip and the wiring pattern on the circuit board are put into contact as a tentative pressure bonding by heating and pressurizing at a temperature greater than or equal to 50°C and a pressure greater than or equal to 1 mN/bump for a time of 0.1 second, and then the bonding be carried out under the foregoing conditions. After the bonding is carried out, the circuit board with the semiconductor chip may be heated at a temperature greater than or equal to 50°C and less than or equal to 200°C for greater than or equal to 10 seconds and less than or equal to 24 hours, according to need.

In addition, the resin composition of the present invention can be also used as a resin composition for manufacturing a die attach film, a dicing die attach film, a lead frame fixing tape, a heat dissipating plate, a reinforcing plate, an adhesive for a shield material, or a solder resist.

Due to recent remarkable progress of the automation of semiconductor device producing operations, resin compositions and semiconductor chips or circuit boards with resin compositions laminated thereto are required to be capable of being left at room temperature for, preferably, greater than or equal to 30 days and, more preferably, greater than or equal to 60 days, in terms of a storage period before hardening is carried out. If the resin composition of the present invention is used, a semiconductor device excellent in connection reliability which is capable of being stored for greater than or equal to 60 days even at room temperature, and which is free from foaming at the time of bonding and achieves initial conduction by short-time heating and pressuring, and which achieves conduction even when put to a thermal cycle test of -40°C to 125°C after the moisture absorption reflow, can be obtained.

### EXAMPLES

Hereinafter, the present invention will be described with reference to examples and the like. However, the present invention is not limited by these examples.

### <COMPOSITION ANALYSIS METHOD FOR SURFACE OF INORGANIC PARTICLE>

A composition analysis of the surface of inorganic particle was conducted by Fourier transform infrared spectroscopy. In the case where the inorganic particle was not a powder body, but in a state of being dispersed in a dispersion liquid, the inorganic particle was extracted from the dispersion liquid as below. Firstly, using an ultracentrifuge "CS100GXL" (made by Hitachi Koki Co., Ltd.), a centrifugal separation process was carried out at 30000 rpm for 30 minutes on what was obtained by thinning the dispersion liquid of the inorganic particle to 100 times with a solvent used in the dispersion liquid and sufficiently stirring the thinned dispersion liquid. Next, aggregates of inorganic particles sedimented on the bottom of the container were gathered, and ware dried, so that a powder body of inorganic particle was obtained. With respect to the powder of inorganic particle, a composition analysis was carried out by using a Fourier transform infrared spectroscopic device "IRPrestige-21" (trade name, made by Shimadzu Corporation) to determine the presence or absence of an absorption band resulting from an unsaturated double bond.

### <MEASUREMENT METHOD FOR DISPERSED PARTICLE DIAMETER OF INORGANIC PARTICLE IN RESIN COMPOSITION SHEET>

A resin composition sheet was cut into thin films of 100 nm in thickness by an ultrathin sectioning method, and inorganic particles in the resin composition sheet were observed by using a transmission electron microscopy H-7100FA (made by Hitachi, Ltd.). The acceleration voltage was 100 kV. The observed images were taken as digital images into a computer and, using image processing software FlvFs (made by Flovel Co., Ltd.), particle diameters of arbitrary 100 particles observed were measured in a spherical approximation, and an average particle diameter thereof was calculated. In the case where primary particles existed aggregated, a particle diameter thereof as an aggregate was measured.

### <MEASUREMENT METHOD FOR TOTAL LIGHT TRANSMITTANCE OF RESIN COMPOSITION SHEET>

A quartz substrate was placed on a hot plate at 80°C, and a resin composition sheet was laminated on top of the substrate by using a hand roller to make a test piece. Using a haze meter "HGM-2DP" (made by Suga Test Instruments Co., Ltd.), the total light transmittance of the resin composition sheet was measured.

### <MEASUREMENT METHOD FOR MINIMUM MELT VISCOSITY OF RESIN COMPOSITION SHEET>

The viscoelasticity property of each resin composition sheet was measured by using a dynamic viscoelasticity measurement device "AG-G2" (trade name, made by TA Instruments). Firstly, several resin composition sheets were laminated together to prepare a sheet of 0.8 mm in thickness, which was cut into a circular shape of 15 mm in diameter to make test pieces. As for the measurement conditions, the measurement was conducted while temperature was raised from 40°C to 150°C at a temperature rise rate of 2°C/min and a measurement frequency of 0.5 Hz. The complex viscosity was measured, and the lowest value of complex viscosity within the measurement range was determined as a minimum melt viscosity, and the temperature at that time was read.

### <MEASUREMENT METHOD FOR FRACTURE ELONGATION OF HARDENED MATERIAL OF RESIN COMPOSITION SHEET>

The fracture elongations of hardened materials of resin composition sheets were measured as follows. Firstly, several resin composition sheets were laminated together on a hot plate at 80°C by using a hand roller to prepare a sheet of 1.0 mm in thickness, which was subjected to a heating treatment at 180°C for 2 hours, so that a hardened material of a resin composition sheet was obtained. The obtained hardened material was cut into strips of 10 mm × 80 mm to make test pieces, by using a dicing device "DAD-3350" (trade name, made by DISCO Corporation). Subsequently, using a universal testing machine "Model 1185" (trade name, made by Instron), each test piece was pulled in the lengthwise direction of the strip while both end portions were held. The rate of elongation at the time of fracture of the test piece was determined as a fracture elongation. The pulling speed during the measurement was 1 mm/min, and an average of measurements of five test pieces was calculated.

### <SYNTHESIS OF ORGANIC SOLVENT-SOLUBLE POLYIMIDE> ORGANIC SOLVENT-SOLUBLE POLYIMIDE A

In a dry nitrogen gas stream, 4.82 g (0.0165 mol) of 1,3-bis(3-aminophenoxy)benzene (hereinafter, termed APB-N), 3.08 g (0.011 mol) of 3,3'-diamino-4,4'-dihydroxydiphenyl sulfone (hereinafter, termed ABPS), 4.97 g (0.02 mol) of 1,3-bis(3-aminopropyl)tetramethyl disiloxane (hereinafter, termed SiDA), and 0.47 g (0.005 mol) of aniline as a terminal sealing agent were dissolved in 130 g of NMP. Into this, 26.02 g (0.05 mol) of 2,2-bis{4-(3,4-dicarboxyphenoxy)phenyl}propane dianhydride (hereinafter, termed BSAA) was added together with 20 g of NMP, and a reaction was allowed to occur at 25°C for 1 hour, and then stirring was conducted at 50°C for 4 hours. After that, stirring was further conducted at 180°C for 5 hours. After the stirring ended, the solution was put into 3 L of water, and precipitation was recovered by filtration. The precipitation, after being washed with water 3 times, was dried at 80°C for 20 hours by using a vacuum dryer. The obtained polymer solid was subjected to infrared spectroscopic measurement, absorption peaks of an imide structure resulting from polyimide were detected in the vicinity of 1780 cm⁻¹ and the vicinity of 1377 cm⁻¹. In this manner, an organic solvent-soluble polyimide A having a functional group capable of reacting with an epoxy group and containing 11.6 wt% of a structure represented by the general formula (1) was obtained. When 6 g of tetrahydrofuran was added to 4 g of the organic solvent-soluble polyimide A and stirring was conducted at 23°C, dissolution occurred.

### ORGANIC SOLVENT-SOLUBLE POLYIMIDE B

In a dry nitrogen gas stream, 24.54 g (0.067 mol) of 2,2-bis(3-amino-4-hydroxyphenyl)hexafluoropropane (hereinafter, termed BAHF), 4.97 g (0.02 mol) of SiDA, and 1.86 g (0.02 mol) of aniline as a terminal sealing agent were dissolved in 80 g ofNMP. Into this, 31.02 g (0.1 mol) of bis(3,4-dicarboxyphenyl)ether dianhydride (hereinafter, termed ODPA) was added together with 20 g of NMP, and a reaction was allowed to occur at 20°C for 1 hour, and then stirring was conducted at 50°C for 4 hours. After that, 15 g of xylene was added, and stirring was conducted at 180°C for 5 hours while the azeotropy of water with xylene was allowed to progress. After the stirring ended, the solution was put into 3 L of water to obtain a white precipitation. This precipitation was recovered by filtration, and was washed with water 3 times, and then was dried at 80°C for 20 hours by using a vacuum dryer. Infrared spectroscopic measurement of the obtained polymer solid was conducted, and absorption peaks of an imide structure resulting from polyimide were detected in the vicinity of 1780 cm⁻¹ and the vicinity of 1377 cm⁻¹. In this manner, an organic solvent-soluble polyimide B having a functional group capable of reacting with an epoxy group and containing 7.5 wt% of a structure represented by the general formula (1) was obtained. When 6 g of tetrahydrofuran was added to 4 g of the organic solvent-soluble polyimide B and stirring was conducted at 23°C, dissolution occurred.

### <PREPARATION OF DISPERSION LIQUID OF INORGANIC PARTICLE>

### DISPERSION LIQUID A

50 g of secondary silica particle "NanoTek (registered trademark)" (trade name, made by C. I. Kasei Company, Limited, spherical silica particle, 25 nm in average primary particle diameter), 1 g of silane coupling agent "KBM5103" (trade name, chemical name: 3-acryloxypropyl trimethoxysilane, made by Shin-Etsu Chemical Co., Ltd.), and 50 g of methyl isobutyl ketone (hereinafter, termed MIBK) were mixed, and a ball mill dispersion treatment was carried out on a ball mill rack at 40°C for 24 hours. In the ball mill dispersion treatment, a zirconia ball "YTZ Ball" (trade name, made by Nikkato Corporation) whose diameter was 0.5 mm was used. After the treatment, the zirconia ball was removed by a sifter to obtain a dispersion liquid A. With respect to the dispersion liquid A, a composition analysis of the surface of the inorganic particle was carried out, and the presence of a compound having an acryloxy group was confirmed.

### DISPERSION LIQUID B

A dispersion liquid B was obtained in substantially the same manner as in the preparation method for the dispersion liquid A, except that "KBM503" (trade name, chemical name: 3-methacryloxypropyl trimethoxysilane, made by Shin-Etsu Chemical Co., Ltd.) was used instead of "KBM5103" as a silane coupling agent. With respect to the dispersion liquid B, a composition analysis of the surface of the inorganic particle was carried out, and the presence of a compound having a methacryloxy group was confirmed.

### DISPERSION LIQUID C

50 g of secondary silica particle "YA050C-SV2" (trade name, made by Admatechs Company Limited, spherical silica particle, surface treated with vinyl trimethoxysilane, 50 nm in average primary particle diameter) and 50 g of propylene glycol monomethyl ether acetate (hereinafter, termed PGMEA) were mixed, and then a ball mill dispersion treatment was carried out on a ball mill rack at room temperature for 3 hours. In the ball mill dispersion treatment, a zirconia ball "YTZ Ball" (trade name, made by Nikkato Corporation) whose diameter was 0.5 mm was used. After the treatment, the zirconia ball was removed by a sifter to obtain a dispersion liquid C. With respect to the dispersion liquid C, a composition analysis of the surface of the inorganic particle was carried out, and the presence of a compound having a vinyl group was confirmed.

### DISPERSION LIQUID D

A dispersion liquid D was obtained in substantially the same manner as in the preparation method for the dispersion liquid C, except that "YA050C-SM1" (trade name, made by Admatechs Company Limited, spherical silica particle, surface treated with 3-methacryloxypropyl trimethoxysilane, 50 nm in average primary particle diameter) was used as silica secondary particle. With respect to the dispersion liquid D, a composition analysis of the surface of the inorganic particle was carried out, and the presence of a compound having a methacryloxy group was confirmed.

### DISPERSION LIQUID E

100 g of a dispersion liquid of silica particle "MP-2040" (trade name, made by Nissan Chemical Industries, Ltd., spherical silica particle, 200 nm in average primary particle diameter, an aqueous dispersion liquid having a silica concentration of 40 wt%) and 1 g of a silane coupling agent "KBM503" (trade name, chemical name: 3-methacryloxypropyl trimethoxysilane, made by Shin-Etsu Chemical Co., Ltd.) were put into a flask of 300 mL, and the flask was submerged in a hot bath at 40°C, and was kept for 24 hours while the liquid was being stirred. After the treatment, the solvent was removed by using a rotary evaporator, and drying was conducted at 60°C for 1 hour. The composition analysis of the surface of the obtained inorganic particle was carried out, and the presence of a compound having a methacryloxy group was confirmed. Subsequently, 30g of the obtained inorganic particle was mixed with 30 g of PGMEA, and the ball mill dispersion treatment was carried out on a ball mill rack at room temperature for 3 hours. In the ball mill dispersion treatment, a zirconia ball "YTZ Ball" (trade name, made by Nikkato Corporation) whose diameter was 0.5 mm was used. After the treatment, the zirconia ball was removed by a sifter to obtain a dispersion liquid E.

### DISPERSION LIQUID F

100 g of a dispersion liquid of silica particle "MEK-AC-5102" (trade name, made by Nissan Chemical Industries, Ltd., 90 nm in average primary particle diameter, surface treated with 3-methacryloxypropyl trimethoxysilane, a methyl ethyl ketone dispersion liquid having a silica concentration of 40 wt%) was put into a flask of 300 mL, and the solvent was removed by using a rotary evaporator, and drying was conducted at 60°C for 1 hour. The composition analysis of the surface of the inorganic particle obtained was carried out, and the presence of a compound having a methacryloxy group was confirmed. Subsequently, 30g of the obtained inorganic particle was mixed with 30 g of PGMEA, and the ball mill dispersion treatment was carried out on a ball mill rack at room temperature for 3 hours. In the ball mill dispersion treatment, a zirconia ball "YTZ Ball" (trade name, made by Nikkato Corporation) whose diameter was 0.5 mm was used. After the treatment, the zirconia ball was removed by a sifter to obtain a dispersion liquid F.

In addition, various materials used in Examples and Comparative Examples are as follows.

### <EPOXY COMPOUND>

### •SOLID-STATE EPOXY COMPOUND

EPICLON (registered trademark) HP-7200 (trade name, epoxy equivalent: 257 g/eq, basic skeleton: dicyclopentadiene, made by DIC Corporation)
EPICLON (registered trademark) HP-7200H (trade name, epoxy equivalent: 277 g/eq, basic skeleton: dicyclopentadiene, made by DIC Corporation)
EPICLON (registered trademark) N-865 (trade name, epoxy equivalent 210 g/eq, basic skeleton: phenol novolac, made by DIC Corporation)

### •LIQUID-STATE EPOXY COMPOUND

jER YL980 (trade name, 185 g/eq, basic skeleton: bisphenol A, made by Mitsubishi Chemical Corporation)
jER 152 (trade name, 175 g/eq, basic skeleton: phenol novolac, made by Mitsubishi Chemical Corporation)
Epolight 4000 (trade name, 230 g/eq, basic skeleton: hydrogenated bisphenol A, made by Kyoeisha Chemical Co., Ltd.)
EPICLON (registered trademark) HP-4032 (trade name, 152 g/eq, basic skeleton: naphthalene, made by DIC Corporation).

### <MICROCAPSULE TYPE HARDENING ACCELERATION AGENT>

NOVACURE (registered trademark) HX-3941HP (trade name, made by Asahi Kasei E-materials Corp.)): in NOVACURE (registered trademark) HX-3941HP, (microcapsule type hardening acceleration agent)/(liquid-state epoxy compound) is 1/2, and in the liquid-state epoxy compound contained, (bisphenol A-TYPE epoxy compound)/(bisphenol F-type epoxy compound) = 1/4. As for the amounts of NOVACURE (registered trademark) HX-3941HP mentioned in Tables 1 to 5, the amounts mentioned in parentheses indicate the amounts of the microcapsule type hardening acceleration agent contained (parts by weight).

### <ACIDIC ACRYLATE>

HOA-MS, HOA-MPL, HOA-MPE, Epoxy Ester 3002A (which are trade names, made by Kyoeisha Chemical Co., Ltd.)

### <OTHER ACRYLATES (WITHOUT CARBOXYL GROUP OR HYDROXYL GROUP)>

DCP-M and DPE-6A (which are trade names, made by Kyoeisha Chemical Co., Ltd.).

### <SILICA PARTICLE DISPERSION LIQUID>

YA050C-KJC (trade name, made by Admatechs Company Limited, spherical silica particle, surface treated with 3-methacryloxypropyl trimethoxysilane, 50 nm in average primary particle diameter, an MIBK dispersion liquid having a silica concentration of 50 wt%)

YA050C-KJA (trade name, made by Admatechs Company Limited, spherical silica particle, 50 nm in average primary particle diameter, surface treated with phenyl trimethoxysilane, an MIBK dispersion liquid having a silica concentration of 50 wt%) YA050C-KJE (trade name, made by Admatechs Company Limited, spherical silica particle, 50 nm in average primary particle diameter, surface treated with 3-glycidoxypropyl trimethoxysilane, an MIBK dispersion liquid having a silica concentration of 50 wt%)

When the composition analysis of the inorganic particle was carried out with respect to the foregoing silica dispersion liquids, the presence of a compound having a methacryloxy group was confirmed only with respect to "YA050C-KJC", and the presence of a compound having an unsaturated double bond was not confirmed with respect to the other dispersion liquids.

### EXAMPLE 1 - for reference

The (a) to (f) components were compounded so that composition ratios shown in Table 1 were realized, and a treatment of 3 hours was carried out so the material was uniformly mixed, by using a ball mill, whereby a paste-state resin composition was prepared. As for the ball mill, a zirconia ball "YTZ Ball" (trade name, made by Nikkato Corporation) whose diameter was 5 mm was used. After the ball mill treatment, the zirconia ball was removed by a sifter to obtain a paste-state resin composition.

### (1) PRESERVATION STABILITY EVALUATION OF PASTE-STATE RESIN COMPOSITION (PRESERVATION STABLE PERIOD (CHANGE IN VISCOSITY WITHIN 10%))

The preservation stability of the paste-state resin composition was evaluated by measuring changes in the viscosity over time. Firstly, the viscosity of the obtained resin composition was measured, and the viscosity when the resin composition was stored at room temperature was measured every several days. The number of storage days having passed when the viscosity increased by greater than or equal to 10% from the initial viscosity was determined as a preservation stability. The viscosity was measured at room temperature by using a rotational viscometer "RE-115L" made by Toki Sangyo Co., Ltd.. Results are shown in Table 1.

### (2) PREPARATION AND EVALUATION OF RESIN COMPOSITION SHEET

A paste-state resin composition was applied, by using a bar coater, onto a mold release film "SR-3" (trade name, made by Otsuki Industrial Co., Ltd.) of 75 µm which was an exfoliative substrate, and drying was carried out at 80°C for 10 minutes. Herein, the application thickness was adjusted so that the thickness of the resin composition subsequent to the drying would become 50 µm. The state of paste-applied surface was observed under an optical microscope, and the number of aggregates of 10 µm or greater in size in a square region of 10 cm × 10 cm was counted. Evaluation references are as follows, and results of evaluation are shown in Table 1.
A: No aggregates of 10 µm or greater in size were observed.
B: 1 to 9 aggregates of 10 µm or greater in size were observed.
C: 10 to 99 aggregates of 10 µm or greater in size were observed.
D: 100 or more aggregates of 10 µm or greater in size were observed.

A mold release film "SR-7" (trade name, made by Otsuki Industrial Co., Ltd.) of 38 µm in thickness was laminated as another exfoliative substrate to the opposite surface of the resin composition to the aforementioned mold release film "SR-3", whereby a resin composition sheet having exfoliative substrates on both surfaces was obtained.

The minimum melt viscosity and the total light transmittance of the obtained resin composition sheet, the dispersed particle diameter of the inorganic particle in the resin composition sheet, and the fracture elongation of a hardened material of the resin composition sheet were measured. Results are shown in Table 1.

### (3) STEP OF LAMINATING RESIN COMPOSITION SHEET TO BUMP-FORMED WAFER

The laminationg of the aforementioned resin composition sheet having exfoliative substrates on both surfaces to a bump-formed wafer was carried out by using a laminator "VTM-200M" (trade name, made by Takatori Corporation).

Firstly, the exfoliative substrate SR-7 was exfoliated from the resin composition sheet to expose the resin composition. Subsequently, the resin composition surface of the resin composition sheet was laminated at a temperature of 80°C and a laminating speed of 20 mm/s to a bump electrode-formed surface of a semiconductor wafer (200 mm in diameter, 625 µm in thickness) with bump electrodes of 35 µm in average height (448 bumps/chip, 60 µm in pitch, peripheral arrangement, gold stud bumps) which was fixed on a laminator stage. The extraneous resin composition around the semiconductor wafer was cut off with a cutter blade to obtain a semiconductor wafer with the resin composition sheet laminated thereto in a state where the bump electrodes are buried in the resin composition.

### (4) DICING STEP

The semiconductor wafer with the laminated resin composition sheet obtained as in the foregoing (3) was fixed to a tape frame. The fixation was carried out by laminating a dicing tape "UHP-110B" (trade name, made by Toyo Adtec Co., Ltd.) to the wafer substrate surface opposite the bump electrodes, by using a wafer mounter device "FM-114" (trade name, made by Technovision, Inc.). Subsequently, the exfoliative substrate SR-3 was exfoliated from the resin composition sheet to expose the resin composition. The tape frame was fixed on a cutting stage of a dicing device "DAD-3350" (trade name, made by DISCO Corporation) so that the resin composition surface was at top, and alignment was carried out by using a CCD camera of the dicing device. The alignment was carried out by reading an alignment mark on the semiconductor wafer surface via an autoalignment function of the dicing device. With regard to the dicing device, there are two kinds of illumination for illuminating the stage: illumination (epi-light) perpendicularly striking the stage, and illumination (oblique light) obliquely striking the stage. When the alignment mark is to be read through a film that scatters light and is low in transparency, the oblique light illumination allows clearer recognition of the alignment mark than the epi-light illumination. Therefore, the alignment mark being able to be recognized in both the epi-light illumination and the oblique light illumination was determined as A, and the alignment mark being unable to be recognized in the epi-light illumination but able to be recognized in the oblique light illumination was determined as B, and the alignment mark being unable to be recognized in either one of the illuminations was determined as C (autoalignment recognition characteristic). Results are shown in Table 1. After the alignment, dicing was implemented to obtain a semiconductor chip (7.3 mm square) equipped with the resin composition.

### (5) FLIP CHIP PACKAGING

The resin composition-equipped semiconductor chip obtained as in the foregoing (4) was flip chip-packaged on a circuit board (gold pad electrode). As a packaging machine, a flip chip bonding device "FC-2000" (trade name, made by Toray Engineering Co., Ltd.) was used. As for the flip chip bonding, tentative pressure bonding was conducted under the conditions of a temperature of 100°C, a pressure of 15 N/chip and a time of 5 seconds, and then final pressure bonding was carried out under the conditions of a temperature of 200°C and a pressure of 100 N/chip, for a time set to 10 seconds. As a result of this, a semiconductor device was obtained.

### (6) RELIABILITY TEST

The semiconductor device produced as in the foregoing (5) was left standing for 168 hours in a constant-temperature and constant-humidity chamber at 85°C and 60%RH, so as to be allowed to absorb moisture. Then, reflow was carried out under the reflow conditions of 260°C and 5 seconds. Then, a cycle in which the semiconductor-equipped circuit board was kept at -40°C for 30 minutes and then was kept at 125°C for 30 minutes was carried out 1000 times.

An electrical conduction test between the substrate and the semiconductor chip of the semiconductor device having been subjected to the aforementioned treatment was carried out (connection reliability test). Samples with conduction were evaluated as pass, and samples without conduction as reject. 10 samples were used to carry out the evaluation, and the number of samples evaluated as pass was recorded. Results are shown in Table 1.

### EXAMPLE 2 to 21 (each for reference), EXAMPLES 22 to 31 AND COMPARATIVE EXAMPLES 1 TO 4

Preparation and evaluation of resin compositions were carried out in substantially the same manner as in Example 1, except that the (a) to (f) components were prepared so that compositions ratios shown in Tables 1 to 7 were obtained. Results are shown in Tables 1 to 7.

In Tables 1 to 4, Examples 1 to 21 do not fall under the scope of the present invention.

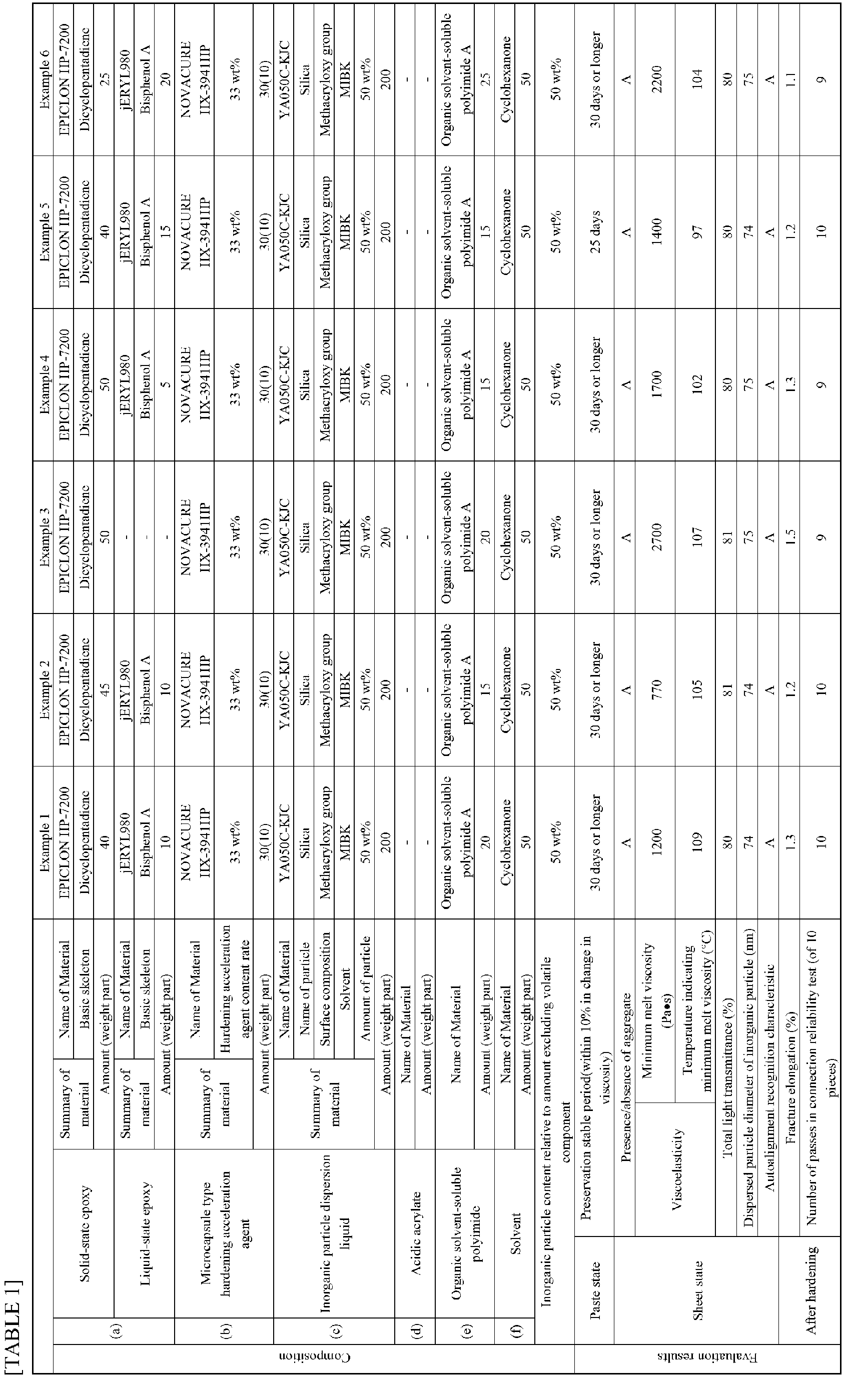

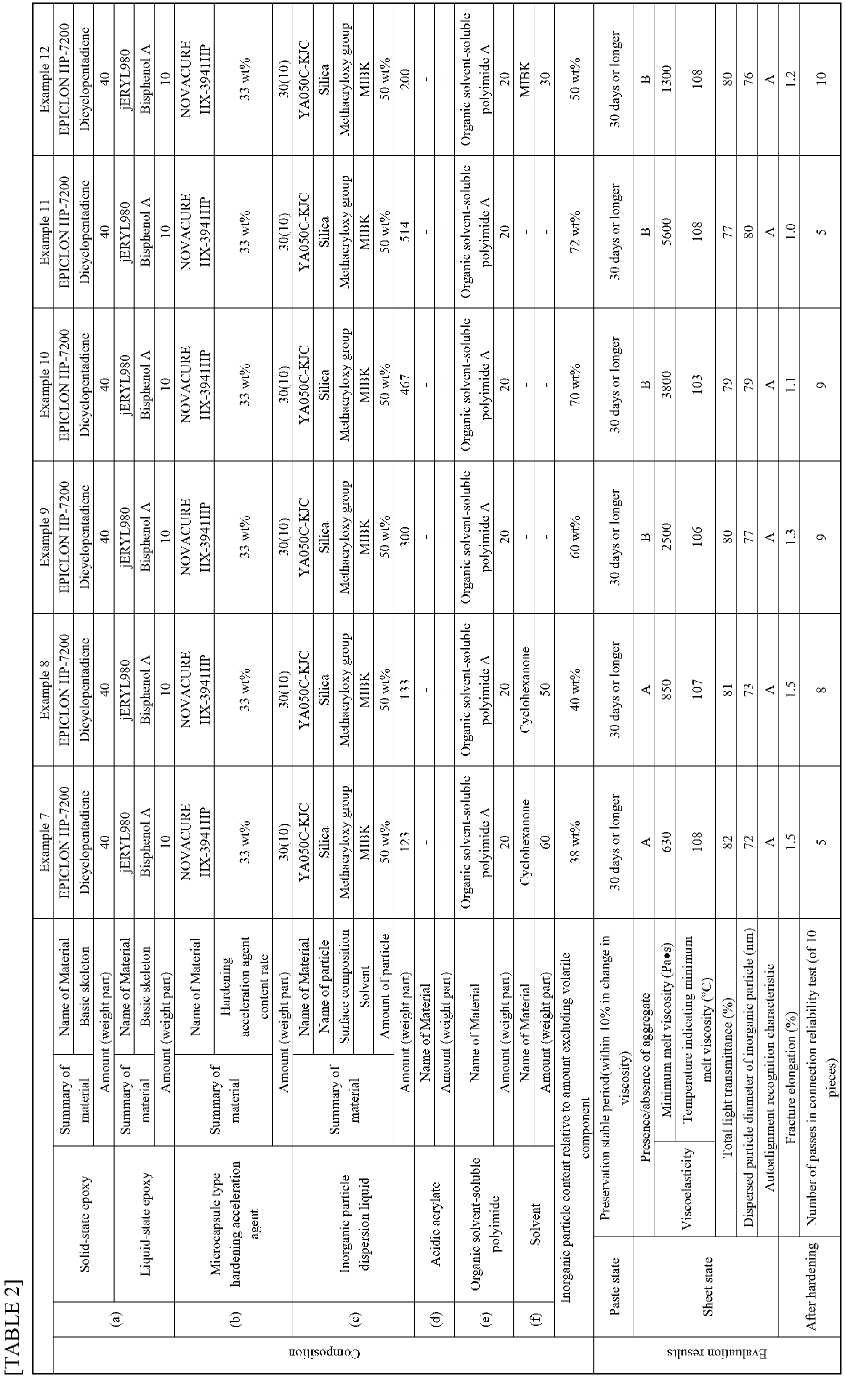

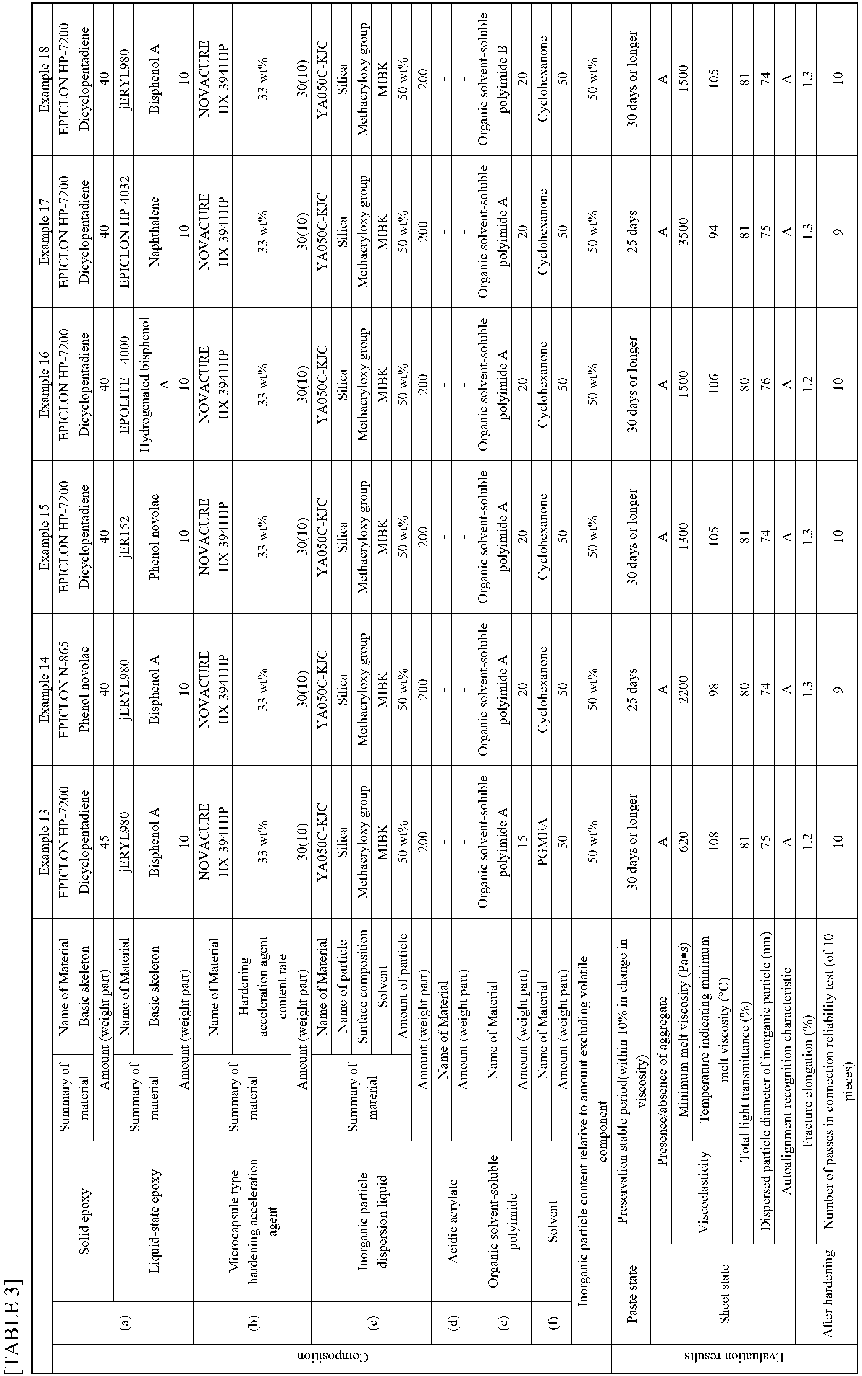

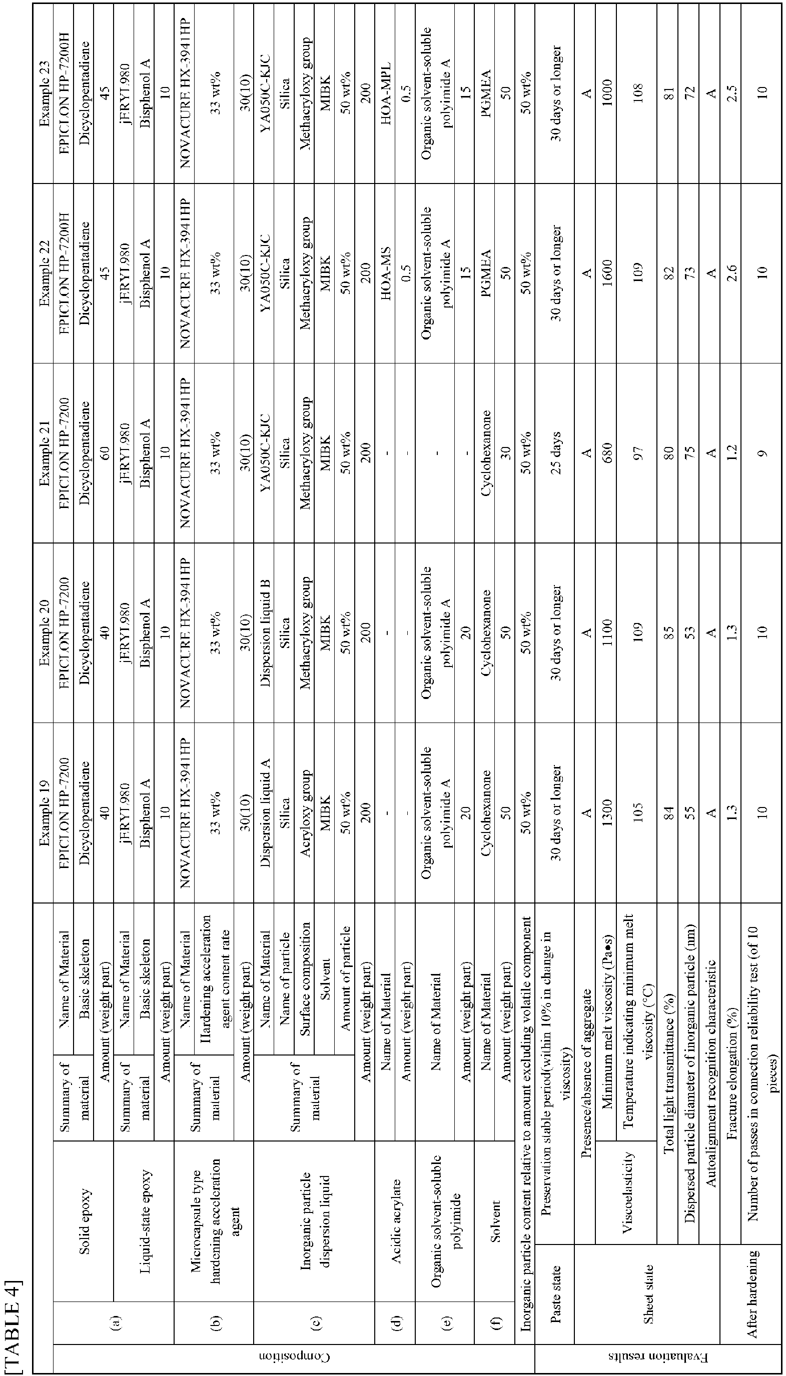

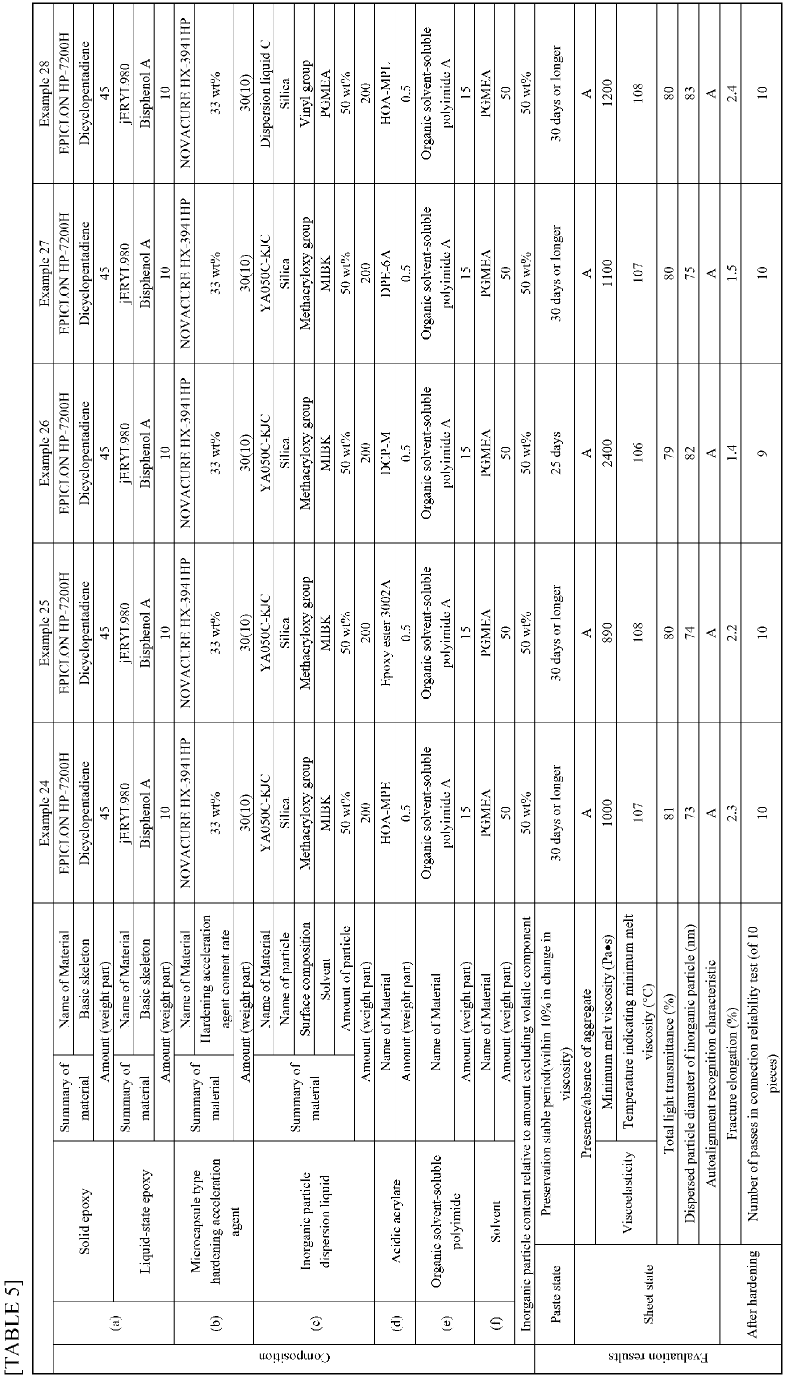

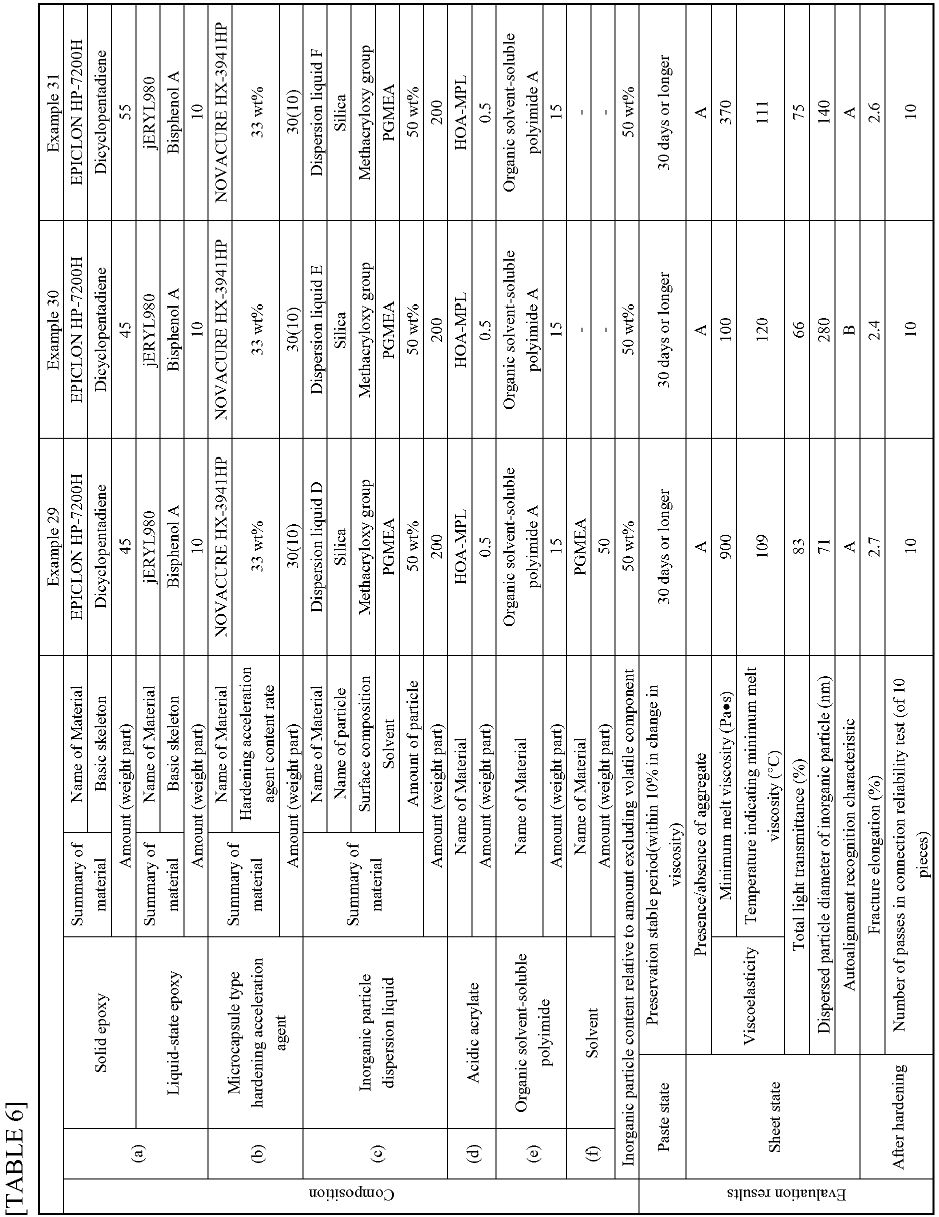

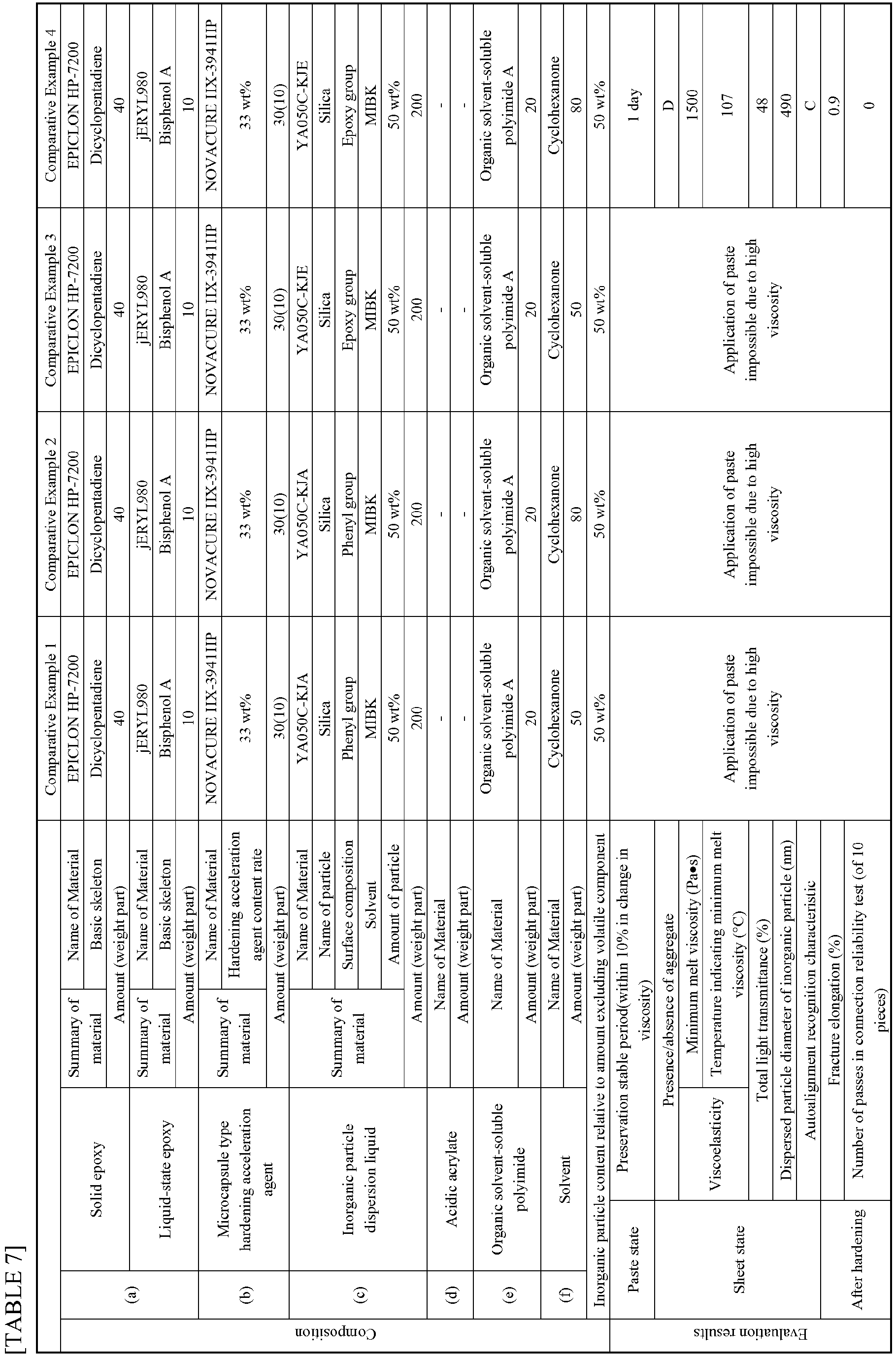

### INDUSTRIAL APPLICABILITY

The resin composition of the present invention can be applied as an adhesive for use for adhesion between an electronic component part or a heat dissipation plate for use in a personal computer or mobile terminal and a printed board or a flexible substrate, adhesion between electronic component parts, and adhesion between substrates. More particularly, the resin composition of the present invention is suitably applicable as a resin composition for use for adhering a semiconductor chip, such as an IC or an LSI, to a circuit board, such as a flexible substrate, a glass epoxy substrate, a glass substrate, or a ceramic substrate.

## Claims

1. A resin composition containing (a) an epoxy compound, (b) a microcapsule type hardening acceleration agent, (c) an inorganic particle whose surface is modified with a compound that has an unsaturated double bond, and (d) a compound that has (d1) a group selected from an acryloxy group and a methacryloxy group and (d2) a group selected from a carboxyl group and a hydroxyl group.

2. The resin composition according to claim 1, wherein the (c) inorganic particle whose surface is modified with the compound that has the unsaturated double bond is (c) an inorganic particle whose surface is modified with a compound that has a group selected from an acryloxy group and a methacryloxy group.

3. The resin composition according to claim 1 or 2, wherein the (a) epoxy compound is an epoxy compound having a dicyclopentadiene skeleton.

4. The resin composition according to any one of claims 1 to 3, further containing (e) an organic solvent-soluble polyimide.

5. The resin composition according to any one of claims 1 to 4, wherein the (c) inorganic particle is a silica particle.

6. The resin composition according to any one of claims 1 to 5, wherein a dispersed particle diameter of the (c) inorganic particle is 1 to 300 nm.

7. A resin composition sheet comprising the resin composition according to any one of claims 1 to 6.

8. A semiconductor device in which two circuit members are electrically connected via the resin composition according to any one of claims 1 to 6 or the resin composition sheet according to claim 7.

9. A production method for a semiconductor device, in which method the resin composition according to any one of claims 1 to 6 or the resin composition sheet according to claim 7 is interposed between a first circuit member and a second circuit member, and the first circuit member and the second circuit member are electrically connected by heating and pressurizing.

## Patentansprüche

1. Harzzusammensetzung umfassend (a) eine Epoxidverbindung, (b) ein mikrokapselartiges Härtungsbeschleunigungsmittel, (c) einen anorganischen Partikel, dessen Oberfläche mit einer Verbindung, welche eine ungesättigte Doppelbindung aufweist, modifiziert ist, und (d) eine Verbindung, welche (d1) eine Gruppe, welche ausgewählt ist aus einer Acryloxygruppe und einer Methacryloxygruppe und (d2) eine Gruppe, welche ausgewählt ist aus einer Carboxylgruppe und einer Hydroxylgruppe, aufweist.

2. Harzzusammensetzung nach Anspruch 1, wobei der (c) anorganische Partikel, dessen Oberfläche mit der Verbindung mit der ungesättigten Doppelbindung modifiziert ist, (c) ein anorganischer Partikel, dessen Oberfläche mit einer Verbindung, welche eine Gruppe ausgewählt aus einer Acryloxygruppe und einer Methacryloxygruppe aufweist, modifiziert ist, ist.

3. Harzzusammensetzung nach Anspruch 1 oder 2, wobei die (a) Epoxidverbindung eine Epoxidverbindung mit einem Dicyclopentadiengerüst ist.

4. Harzzusammensetzung nach einem der Ansprüche 1 bis 3 ferner umfassend (e) ein in einem organischen Lösungsmittel lösliches Polyimid.

5. Harzzusammensetzung nach einem der Ansprüche 1 bis 4, wobei (c) der anorganische Partikel ein Siliciumdoxidpartikel ist.

6. Harzzusammensetzung nach einem Ansprüche 1 bis 5, wobei ein verteilter Partikeldurchmesser des (c) anorganischen Partikels 1 bis 300 nm beträgt.

7. Harzzusammensetzungsplatte umfassend die Harzzusammensetzung nach einem der Ansprüche 1 bis 6.

8. Halbleitervorrichtung, in welcher Stromkreiselemente elektrisch mit der Harzzusammensetzung nach einem der Ansprüche 1 bis 6 oder der Harzzusammensetzungsplatte nach Anspruch 7 verbunden sind.

9. Herstellungsverfahren für eine Halbleitervorrichtung, wobei für das Herstellungsverfahren die Harzzusammensetzung nach einem der Ansprüche 1 bis 6 oder die Harzzusammensetzungsplatte nach Anspruch 7 zwischen ein erstes Stromkreiselement und ein zweites Stromkreiselement angeordnet wird, und das erste Stromkreiselement und das zweite Stromkreiselement elektrisch durch Erwärmen und Druckbeaufschlagen verbunden werden.

## Revendications

1. Composition de résine contenant (a) un composé époxy, (b) un agent d'accélération de durcissement de type microcapsule, (c) une particule inorganique dont la surface est modifiée avec un composé qui a une double liaison insaturée, et (d) un composé qui a (d1) un groupe choisi parmi un groupe acryloxy et un groupe méthacryloxy et (d2) un groupe choisi parmi un groupe carboxyle et un groupe hydroxyle.

2. Composition de résine selon la revendication 1, dans laquelle la particule inorganique (c) dont la surface est modifiée avec le composé qui a la double liaison insaturée est (c) une particule inorganique dont la surface est modifiée avec un composé qui a un groupe choisi parmi un groupe acryloxy et un groupe méthacryloxy.

3. Composition de résine selon la revendication 1 ou 2, dans laquelle le composé époxy (a) est un composé époxy ayant un squelette de dicyclopentadiène.

4. Composition de résine selon l'une quelconque des revendications 1 à 3, contenant en outre (e) un polyimide soluble dans un solvant organique.

5. Composition de résine selon l'une quelconque des revendications 1 à 4, dans laquelle la particule inorganique (c) est une particule de silice.

6. Composition de résine selon l'une quelconque des revendications 1 à 5, dans laquelle un diamètre de particule dispersée de la particule inorganique (c) est compris entre 1 et 300 nm.

7. Feuille de composition de résine comprenant la composition de résine selon l'une quelconque des revendications 1 à 6.

8. Dispositif à semi-conducteur dans lequel deux éléments de circuit sont reliés électriquement par l'intermédiaire de la composition de résine selon l'une quelconque des revendications 1 à 6 ou de la feuille de composition de résine selon la revendication 7.

9. Procédé de production d'un dispositif à semi-conducteur, dans lequel procédé, la composition de résine selon l'une quelconque des revendications 1 à 6 ou la feuille de composition de résine selon la revendication 7 est interposée entre un premier élément de circuit et un deuxième élément de circuit, et le premier élément de circuit et le deuxième élément de circuit sont reliés électriquement par chauffage et par mise sous pression.
